# EUROPEAN PATENT APPLICATION

(11) **EP 4 524 656 A1**
(43) Date of publication of application: **19.03.2025**
(21) Application number: 24196510.2
(22) Date of filing: 26.08.2024
(51) Int. Cl.: G03F 7/09, G03F 7/40

(54) **COMPOUND FOR FORMING METAL-CONTAINING FILM, COMPOSITION FOR FORMING METAL-CONTAINING FILM, AND PATTERNING PROCESS**

(30) Priority: 28.08.2023 JP 2023138392
(71) Applicant: SHIN-ETSU CHEMICAL CO., LTD., Tokyo 1000005 (JP)
(72) Inventor: Iwamori, Shohei, Niigata (JP); Kobayashi, Naoki, Niigata (JP); Kori, Daisuke, Niigata (JP); Ishiwata, Kenta, Niigata (JP)
(74) Representative: Sonnenhauser, Thomas Martin

(57) **Abstract**

The present invention is a compound for forming a metal-containing film, being a reaction product between a compound having two or more diol structures per molecule and a Sn compound, and being a monomolecular compound containing two or more Sn atoms per molecule. This can provide: a metal compound having better dry etching resistance than conventional organic underlayer film materials and also having high filling and planarizing properties; a composition for forming a metal-containing film containing the compound; and a patterning process in which the composition is used as a resist underlayer film material.

## Description

### TECHNICAL FIELD

The present invention relates to: a composition for forming a metal-containing film that can be used for fine patterning according to a multilayer resist method in a semiconductor device manufacturing process; and a patterning process using the composition.

### BACKGROUND ART

As LSIs advance toward higher integration and higher processing speed, miniaturization of pattern rule is progressing rapidly. As a cutting-edge technology for miniaturization, ArF immersion lithography has been adopted for mass-producing 45-nm node devices and smaller. In addition to ArF immersion exposure, double exposure (double patterning) processes have been put to practical use in generations of 28-nm node devices and smaller, so that the formation of narrow-pitch patterns that exceed the optical limit has also become possible.

Furthermore, in the production of 20-nm node and smaller devices, studies have been carried out on multiple exposure (multi-patterning) processes for forming a pattern with a narrower pitch by repeating exposure and etching three or more times. However, multiple exposure processes have an increased number of steps, and are faced with the situation that costs rise considerably due to degradation in productivity caused by longer time spent in manufacturing and more frequent generation of defects.

In recent years, extreme ultraviolet ray (EUV) lithography with a wavelength of 13.5 nm is attracting attention as an effective technology to replace a combination of ArF immersion lithography and multiple exposure process. By using this technology, it has become possible to form a fine pattern with a half pitch of 25 nm or less in one exposure.

Meanwhile, in EUV lithography, resist materials are strongly required to have higher sensitivity to compensate for insufficient output of a light source. However, increase in shot noise accompanying higher sensitization leads to increase in edge roughness (LER and LWR) of line patterns, and compatibility of higher sensitization and low edge roughness is given as an important problem in EUV lithography.

As an attempt to achieve higher sensitivity of a resist or to lower the influence of shot noise, it has been considered in recent years to use a metal material in a resist material. A compound that contains a metallic element, such as barium, titanium, hafnium, zirconium, or tin, has a higher absorbance of EUV light compared to an organic material that does not contain metal, and improvement of photosensitivity of resists and suppression of the influence of shot noise can be expected. Furthermore, a metal-containing resist pattern is expected to achieve a high-selectivity etching process by combining with an underlayer film made from a non-metal material.

For example, resist materials with added metal salt or organometallic complex disclosed in Patent Documents 1 and 2 or non-chemically amplified resist materials that use nanoparticles of metal oxide disclosed in Patent Documents 3 and 4 are considered.

In particular, molecules containing tin are excellent in the absorption of an electron beam and an extreme ultraviolet ray, and are actively researched. In the case of an organotin polymer, which is one such molecule, alkyl ligand is dissociated by light absorption or secondary electrons produced thereby and a resultant is crosslinked with adjacent chains through an oxo bond, and thus this enables the negative tone patterning which may not be removed by an organic developing solution. This organic tin polymer can improve sensitivity while maintaining a resolution and line edge roughness, but has not yet reached the standards for commercial availability (Patent Document 5). In addition, many problems still remain, such as insufficient storage stability regarding change in resist sensitivity.

To solve the problems, there is also consideration of development of the use of a material containing a metal element, such as titanium, hafnium, zirconium, and tin, for a resist underlayer film. There is no need for the improvement for performance, such as the enhancement of exposure sensitivity and the suppression of change in sensitivity in storage environment, which is an issue in resist materials containing metal. In addition, it may be possible to provide a resist underlayer film excellent in dry etching resistance when the metal element is contained. Patent Document 7 reports that a material containing a Ti compound exhibits excellent dry etching resistance to CHF₃/CF₄-based gas and CO₂/N₂-based gas.

On the other hand, filling property is a problem when using a metal compound for a resist underlayer film. For example, in compounds expected to be used in photoresists as in Patent Document 6, there is no mention of heat resistance, but since baking at a high temperature is not expected, there is a risk of insufficient heat resistance, causing filling and film-formability failure. Although there is no mention of filling property in Patent Document 7, a metal oxide compound generally undergoes great thermal shrinkage during baking and induces remarkable degradation of filling after baking at a high temperature. Therefore, there is a concern that such a compound is insufficient as a resist underlayer film material for which high planarizing and filling properties and heat resistance are required. Patent Document 8 reports that a metal compound modified with a particular ligand has excellent filling property. However, the baking temperature in the performed filling property evaluation is a low temperature of 150°C, and there is a concern that the compound is insufficient as a resist underlayer film, which requires heat resistance (for example, resistance to a heat treatment that is performed after the formation of a resist underlayer film in some cases). Patent Document 9 provides a resist underlayer film material excellent in filling property after baking at 400°C by mixing the metal compound reported in Patent Document 8 and an organic polymer having a particular structure. However, since the material is a mixed composition of a metal compound which is inorganic and a polymer which is organic, there are concerns for film formation defects, degradation of storage stability, degradation of dry etching resistance, etc. caused by compatibility failure.

### CITATION LIST

### PATENT LITERATURE

Patent Document 1: JP5708521B2
Patent Document 2: JP5708522B2
Patent Document 3: US9310684B2
Patent Document 4: US2017/0102612A1
Patent Document 5: JP2021-162865A
Patent Document 6: JP7028940B2
Patent Document 7: JP6189758B2
Patent Document 8: JP7050137B2
Patent Document 9: JP2022-521531A

### SUMMARY OF INVENTION

### TECHNICAL PROBLEM

The present invention has been made in view of the above-described circumstances. An object of the present invention is to provide: a metal compound having better dry etching resistance than conventional organic underlayer film materials and also having high filling and planarizing properties; a composition for forming a metal-containing film containing the compound; and a patterning process in which the composition is used as a resist underlayer film material.

### SOLUTION TO PROBLEM

To achieve the object, the present invention provides a compound for forming a metal-containing film, being a reaction product between a compound having two or more diol structures per molecule and a Sn compound, and being a monomolecular compound containing two or more Sn atoms per molecule.

The inventive compound for forming a metal-containing film has better dry etching resistance than conventional organic underlayer film materials and also has high filling and planarizing properties, and it is possible to provide: a composition for forming a metal-containing film containing the metal compound; and a patterning process using the composition as a resist underlayer film material.

The compound for forming a metal-containing film may be represented by the following general formula (M-1) or (M-2), 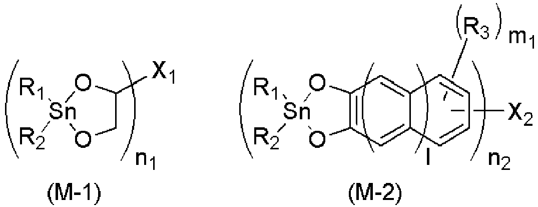 wherein R₁ and R₂ each independently represent a monovalent organic group or a halogen atom; X₁ represents an organic group having a valency of "n₁" selected from the group consisting of a substituted or unsubstituted linear alkyl group having 1 to 20 carbon atoms, a substituted or unsubstituted, branched or cyclic alkyl group having 3 to 70 carbon atoms, a substituted or unsubstituted aliphatic unsaturated hydrocarbon group having 2 to 20 carbon atoms and having one or more double bonds or triple bonds, optionally the alkyl groups and the aliphatic unsaturated hydrocarbon group having an ether group, a thioether group, an ester group, or an amide group, a substituted or unsubstituted aryl group having 6 to 30 carbon atoms, a substituted or unsubstituted arylalkyl group having 6 to 30 carbon atoms, a substituted or unsubstituted triazine ring, a substituted or unsubstituted isocyanuric group, and a substituted or unsubstituted glycoluril group; "n₁" represents an integer of 2 to 6; R₃ represents a substituent other than a hydrogen atom and each independently represents a substituted or unsubstituted alkyl group having 1 to 20 carbon atoms, a substituted or unsubstituted, branched or cyclic alkyl group having 3 to 20 carbon atoms, a substituted or unsubstituted aliphatic unsaturated hydrocarbon group having 2 to 20 carbon atoms and having one or more double bonds or triple bonds, a substituted or unsubstituted alkoxy group having 1 to 20 carbon atoms, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen atom; "l" represents an integer of 0 or 1; "m₁" represents an integer of 0 to 5; X₂ represents a single bond or a linking moiety, the linking moiety being a carbonyl group, an ether group, an ester group, an amide group, an organic group having a valency of "n₂" selected from the group consisting of a substituted or unsubstituted linear alkyl group having 1 to 20 carbon atoms, a substituted or unsubstituted, branched or cyclic alkyl group having 3 to 20 carbon atoms, a substituted or unsubstituted aliphatic unsaturated hydrocarbon group having 2 to 20 carbon atoms and having one or more double bonds or triple bonds, optionally the alkyl group and the aliphatic unsaturated hydrocarbon group having a ketone group, an ether group, an ester group, an amide group, an imine group, a lactone ring, or a sultone ring, a substituted or unsubstituted aryl group having 6 to 36 carbon atoms, a substituted or unsubstituted arylalkyl group having 6 to 36 carbon atoms, and a substituted or unsubstituted triazine ring, or an organic group having a valency of 2×n₂ selected from the group consisting of substituted or unsubstituted, saturated or unsaturated hydrocarbon groups having 2 to 20 carbon atoms and forming a cyclic structure together with the aromatic ring, optionally the hydrocarbon groups having an ether group; and "n₂" represents an integer of 2 to 4.

Here, a heteroalkyl group indicates an alkyl group that further contains one or more (e.g. one, two, three, or four) heteroatoms (e.g. oxygen, sulfur, nitrogen, boron, silicon, or phosphorus) in the main chain of the alkyl group. A heteroatom may be interposed between adjacent carbon atoms within the parent carbon chain of the heteroatom or may be interposed between a carbon atom and the parent molecule thereof (i.e. in the attachment point). However, substituted or unsubstituted alkoxy groups having 1 to 20 carbon atoms and substituted or unsubstituted alkyl groups having 1 to 20 carbon atoms, the groups containing an ester group or an amide group, are excluded.

The structures represented by the general formulae (M-1) and (M-2) make it possible to ensure sufficient molecular weight, so that the sublimation of molecules can be suppressed even at a high temperature. Therefore, it is possible to provide a composition for forming a metal-containing film having excellent film-formability and filling and planarizing properties even after high-temperature baking.

The R₁ in the general formulae (M-1) and (M-2) is preferably a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, or a substituted or unsubstituted arylalkyl group having 7 to 31 carbon atoms.

When the R₁ in the general formulae (M-1) and (M-2) is as described, radical cleavage of tin-carbon bonds occurs during baking, and radicals are generated, so that a crosslinking reaction originating from the radicals occurs. Thus, curability can be enhanced. A compound for forming a metal-containing film having such a structure can achieve both high heat resistance and high thermosetting property, and when the compound is contained in a composition for forming a metal-containing film, it is possible to provide a resist underlayer film material that exhibits better filling property.

In the inventive compound for forming a metal-containing film, the R₂ preferably represents -OC(=O)R₂', R₂' representing a monovalent organic group.

When the R₂ in the general formulae (M-1) and (M-2) is -OC(=O)R₂', the symmetry in the structure of the compound is broken, and therefore, it is possible to provide a composition for forming a metal-containing film excellent in solvent solubility. In addition, in -OC(=O)R₂', the R₂' can be freely changed, so that by incorporating a bulky structure, further improvement in solubility and thermal flowability can be expected. Furthermore, it is also possible to provide a crosslinking structure, and therefore, sublimation products can be suppressed, and the suppression of volume shrinkage, which induces degradation in filling property, can also be expected. In this manner, it is possible to provide a composition for forming a metal-containing film excellent in film-formability and filling and planarizing properties even after high-temperature baking.

In the present invention, the R₂' preferably represents one of the following general formulae (A-1) to (A-4), the following general formula (2), or the following general formula (3), 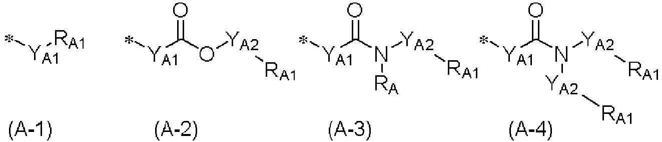 wherein Y_{A1} and Y_{A2} are each identical to or different from each other and represent a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R_{A} represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R_{A1} represents an organic group whose protecting group is to be removed by an action of an acid, heat, or both to generate one or more hydroxy groups or carboxyl groups, R_{A1} being represented by one of the following general formulae (1); and "*" represents an attachment point to the carbonyl group, 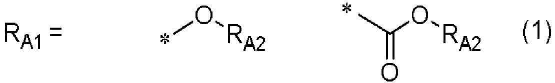 wherein R_{A2} represents an organic group whose protecting group is to be removed by an action of an acid, heat, or both; and "*" represents an attachment point to Y_{A1} or Y_{A2}, 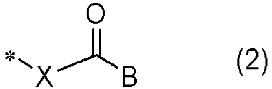 wherein X represents a divalent organic group having 1 to 31 carbon atoms; B represents the following general formula (B); and "*" represents an attachment point to the carbonyl group, 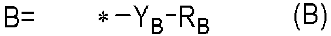 wherein Y_{B} represents a substituted or unsubstituted saturated divalent aliphatic hydrocarbon group having 1 to 20 carbon atoms, a substituted or unsubstituted unsaturated divalent aliphatic hydrocarbon group having 2 to 20 carbon atoms, a substituted or unsubstituted divalent aryl group having 6 to 30 carbon atoms, or a substituted or unsubstituted divalent arylalkyl group having 7 to 31 carbon atoms, optionally Y_{B} being bonded to an adjacent group via an oxygen atom or an NH group; R_{B} represents a hydroxy group or a structure represented by one of the following general formulae (B-1) to (B-3); and "*" represents an attachment point to the carbonyl group, 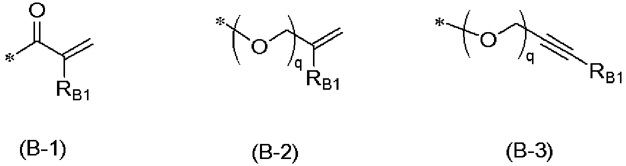 wherein R_{B1} represents a hydrogen atom or a monovalent organic group having 1 to 10 carbon atoms; "q" represents 0 or 1; and "*" represents an attachment point to Y_{B}, 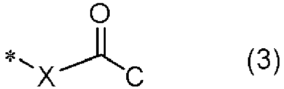 wherein X represents a divalent organic group having 1 to 31 carbon atoms; C represents one of the following general formulae (C-1) to (C-4); and "*" represents an attachment point to the carbonyl group, 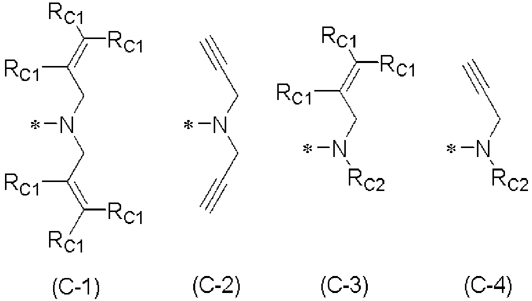 wherein R_{C1}s each independently represent a hydrogen atom or a methyl group and are identical to or different from each other in a single formula; R_{C2} represents a hydrogen atom, a substituted or unsubstituted, saturated or unsaturated monovalent aliphatic hydrocarbon group having 1 to 20 carbon atoms, a substituted or unsubstituted aryl group having 6 to 30 carbon atoms, a substituted or unsubstituted arylalkyl group having 7 to 31 carbon atoms; and "*" represents an attachment point to the carbonyl group.

When the R₂' has a structure represented by one of the general formulae (A-1) to (A-4), a bulky heat/acidlabile group is contained in the structure, and therefore, thermal flowability can be enhanced. Furthermore, when the compound is contained in a composition for forming a metal-containing film, the heat/acid-labile groups are eliminated during baking, so that hydroxy groups and carboxyl groups are generated. The OH or the α-hydrogen of a carboxylic acid generated in this manner react easily with radicals that are generated by the cleavage of tin-carbon bonds when baking is performed, and therefore, a crosslinking reaction occurs, providing excellent thermosetting property. Thus, it is possible to suppress volume shrinkage, which causes the degradation of flatness and filling property, and it is possible to provide a composition for forming a metal-containing film excellent in film-formability and planarizing and filling properties even after high-temperature baking.

When the R₂' has the structure represented by the general formula (2), a hydroxy group or a crosslinking group of one of the structures represented by the general formulae (B-1) to (B-3) is included at an end, and therefore, when the compound is contained in a composition for forming a metal-containing film, the compound reacts easily with radicals that are generated by the cleavage of tin-carbon bonds when baking is performed, and therefore, a crosslinking reaction occurs, and furthermore, the crosslinking groups themselves also undergo a crosslinking reaction, providing excellent thermosetting property. Thus, it is possible to suppress volume shrinkage, which causes the degradation of flatness and filling property, and it is possible to provide a composition for forming a metal-containing film excellent in film-formability and planarizing and filling properties even after high-temperature baking.

When the R₂' has the structure represented by the general formula (3), one of the structures represented by (C-1) to (C-4) is contained, and therefore, the crosslinking-group density is high, providing excellent thermosetting property. Therefore, when the compound is contained in a composition for forming a metal-containing film, volume shrinkage at the time of baking is low, and it is possible to provide a resist underlayer film material excellent in film-formability and planarizing and filling properties even after high-temperature baking.

It is preferable that the Y_{A1} in the general formulae (A-1) to (A-4), the X in the general formula (2), or the X in the general formula (3) is a substituted or unsubstituted unsaturated divalent hydrocarbon group having 2 to 20 carbon atoms.

When the Y_{A1} in the general formulae (A-1) to (A-4), the X in the general formula (2), or the X in the general formula (3) is an unsaturated divalent hydrocarbon group having 2 to 20 carbon atoms, the thermosetting property of the compound for forming a metal-containing film can be further improved.

Furthermore, the Y_{A1} in the general formulae (A-1) to (A-4), the X in the general formula (2), or the X in the general formula (3) may represent one of the following general formulae (4), 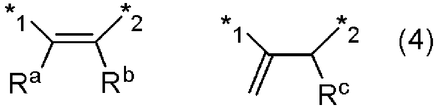 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, substitution positions of "*1" and "*2" optionally being reversed.

When the Y_{A1} in the general formulae (A-1) to (A-4), the X in the general formula (2), or the X in the general formula (3) represents one of the general formulae (4), it is possible to achieve both high thermal flowability and high thermosetting property, and when the compound is contained in a composition for forming a metal-containing film, it is possible to provide a resist underlayer film material that exhibits better planarizing and filling properties.

It is preferable that the "m₁" in the general formula (M-2) is 0 or 1, the R₃ being a hydroxy group when m₁=1.

When the "m₁" in the general formula (M-2) is 0 or 1, the tin content is high, and therefore, excellent etching resistance can be expected. When the R₃ is a hydroxy group in a case where the "m₁" is 1, radical cleavage of tin-carbon bonds occurs at the time of baking, and since hydroxy groups react readily with radicals, curability can be enhanced. Therefore, it is possible to provide a composition for forming a metal-containing film, having excellent film-formability, filling property, and etching resistance even after high-temperature baking.

The compound for forming a metal-containing film preferably satisfies 1.00 ≤ Mw/Mn ≤ 1.50, where Mw is a weight-average molecular weight and Mn is a number-average molecular weight measured by gel permeation chromatography in terms of polystyrene.

A compound for forming a metal-containing film having a dispersity of such a range can be confirmed to be a monomolecular compound and also has even better thermal flowability, and therefore, when the compound is contained in a composition for forming a metal-containing film, not only is it possible to fill favorably a fine structure formed on a substrate, it is also possible to form a resist underlayer film that is flat across the entire substrate.

In addition, the present invention can provide a composition for forming a metal-containing film, the composition functioning as a resist underlayer film material used in manufacturing a semiconductor, the composition comprising: (a) the above-described compound for forming a metal-containing film; and (b) an organic solvent.

Such a composition for forming a metal-containing film contains an organotin compound excellent in solvent solubility, heat resistance, and thermal flowability, and therefore, makes it possible to provide a resist underlayer film material that has better dry etching resistance than conventional organic underlayer film materials and also has high filling and planarizing properties.

The composition is usable as a resist underlayer film used in a multilayer resist method, and the composition can further comprise one or more of (c) a crosslinking agent, (d) a surfactant, (e) a flowability accelerator, and (f) an acid generator.

Furthermore, the organic solvent (b) is preferably a mixture of one or more kinds of organic solvent having a boiling point of lower than 180°C and one or more kinds of organic solvent having a boiling point of 180°C or higher.

When the above-described compound for forming a metal-containing film is provided with thermal flowability by the high-boiling-point solvent being contained, a composition for forming a resist underlayer film is provided with both higher filling property and higher planarizing property.

In addition, the present invention provides a patterning process for forming a pattern in a substrate to be processed, comprising the steps of:
(I-1) applying the inventive composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The patterning process by way of the two-layer resist process makes it possible to form fine patterns on the body to be processed (substrate to be processed).

The present invention also provides a patterning process for forming a pattern in a substrate to be processed, comprising the steps of:
(II-1) applying the inventive composition for forming a metal-containing film onto a substrate to be processed, followed by heating to form a metal-containing film;
(II-2) forming a resist middle layer film on the metal-containing film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal-containing film by dry etching while using the resist middle layer film having the transferred pattern as a mask; and
(II-7) processing the substrate to be processed while using the metal-containing film having the formed pattern as a mask to form the pattern in the substrate to be processed.

The patterning process by way of the three-layer resist process makes it possible to form fine patterns on the body to be processed with high accuracy.

The present invention also provides a patterning process for forming a pattern in a substrate to be processed, comprising the steps of:
(III-1) applying the inventive composition for forming a metal-containing film onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

The patterning process by way of the four-layer resist process makes it possible to form fine patterns on the body to be processed with high accuracy.

In this case, the inorganic hard mask is preferably formed by a CVD method or an ALD method.

When the inorganic hard mask is formed by a CVD method or an ALD method, a fine pattern can be formed on a body to be processed with higher accuracy.

The present invention also provides a patterning process for forming a pattern in a substrate to be processed, comprising the steps of:
(IV-1) forming a resist underlayer film on a substrate to be processed;
(IV-2) applying the inventive composition for forming a metal-containing film onto the resist underlayer film, followed by heating to form a metal-containing film;
(IV-3) forming a resist upper layer film on the metal-containing film by using a photoresist material or forming an organic adhesive film on the metal-containing film by spin-coating and forming a resist upper layer film on the organic adhesive film by using a photoresist material;
(IV-4) subjecting the resist upper layer film to pattern exposure and then development with a developer to form a pattern in the resist upper layer film;
(IV-5) transferring the pattern to the metal-containing film or the organic adhesive film and the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed.

The patterning process by way of the multilayer resist process makes it possible to form fine patterns on the body to be processed with high accuracy.

The present invention also provides a patterning process for forming a pattern in a substrate to be processed, comprising the steps of:
(V-1) forming a resist underlayer film on a substrate to be processed;
(V-2) forming a resist middle layer film or a combination of an organic thin film and an inorganic hard mask middle layer film selected from a silicon oxide film, a silicon nitride film, and a silicon oxynitride film on the resist underlayer film;
(V-3) forming a resist upper layer film on the resist middle layer film or the combination of the organic thin film and the inorganic hard mask middle layer film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the inventive composition for forming a metal-containing film onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing, by dry etching, the resist underlayer film having the formed pattern with an exposed surface to form a reverse pattern of an original pattern on the metal-containing film; and
(V-11) processing the substrate to be processed while using the metal-containing film having the formed reverse pattern as a mask to form the reverse pattern in the substrate to be processed.

The patterning process by way of the reverse process makes it possible to form fine patterns on the body to be processed with even higher accuracy.

In this case, too, the inorganic hard mask is preferably formed by a CVD method or an ALD method.

When the inorganic hard mask is formed by a CVD method or an ALD method, a fine pattern can be formed on a body to be processed with higher accuracy.

### ADVANTAGEOUS EFFECTS OF INVENTION

As described above, the inventive compound for forming a metal-containing film is a monomolecular compound containing two or more Sn atoms per molecule, and is synthesized by allowing a reaction between a compound having two or more diol structures, including catechol structures, and a tin compound. In microscopic terms, bonding with Sn is possible at two hydroxy groups that the diol, such as catechol, has, and bonds need to be cleaved in two places when the organic ligand sublimes, so that the tin-containing compound has better heat resistance than a compound having ordinary monovalent ligands (monodentate ligands), making it possible to suppress volume shrinkage, which induces degradation in filling property. Meanwhile, in macroscopic terms, since multiple Sn atoms can be introduced to one molecule, molecular design to increase the molecular weight while keeping the Sn content high is also possible. Furthermore, since the compound for forming a metal-containing film also contains two different organic groups per Sn atom, the compound is excellent in thermal flowability, and by further modifying the structures of the organic groups, the performance of the compound can be tuned. Accordingly, when the compound is contained in a composition for forming a metal-containing film, it is possible to suppress volume shrinkage, which induces the degradation of filling property, and therefore, it is possible to provide a resist underlayer film material that is excellent in film-formability and planarizing and filling properties even after high-temperature baking.

In particular, in a fine patterning process using a multilayer resist method in a semiconductor device manufacturing process, filling is possible without causing defects such as voids and peeling even on a substrate to be processed having a portion that is difficult to fill and planarize, such as a dense portion of a fine pattern structure having a high aspect ratio exemplified by increasingly miniaturized DRAM. In addition, the inventive compound has better dry etching resistance than conventional coating-type organic resist underlayer film materials, and therefore, a fine pattern can be formed on a body to be processed with even higher precision compared with an organic resist underlayer film.

A composition for forming a metal-containing film containing the inventive compound for forming a metal-containing film contains a tin atom, which has high EUV light absorbance, and therefore, has a sensitizing effect caused by secondary electrons generated from the tin atom during exposure. Furthermore, tin atoms have a great atomic weight, and therefore, have a high effect of suppressing the diffusion of acid from an upper layer resist to a resist underlayer film, and have a characteristic that higher sensitivity can be achieved while sustaining the LWR performance that the resist upper layer film originally has.

### BRIEF DESCRIPTION OF DRAWINGS

FIG. 1 is an explanatory view of an example (three-layer resist process) of the patterning process of the present invention.
FIG. 2 is an explanatory view of an example (forming reverse SOC pattern of a three-layer resist process) of the tone-reversal patterning process of the present invention.
FIG. 3 is an explanatory view of a method for evaluating filling property.
FIG. 4 is an explanatory view of a method for evaluating planarizing property.

### DESCRIPTION OF EMBODIMENTS

As stated above, there have been demands for the development of: a composition for forming a metal-containing film, excellent in filling property and planarization property, used for forming a resist underlayer film that makes it possible to transfer a resist pattern to a substrate to be processed with higher precision in a fine patterning process according to a multilayer resist method; and a compound for forming a metal-containing film useful for the composition.

The present inventors have focused on organotin compounds, which are expected to play an active role in the EUV-exposure generation, and studied earnestly. As stated above, tin atoms, which greatly absorb EUV light, have a sensitizing effect due to secondary electrons generated from the atoms during exposure, and have a characteristic that higher sensitivity can be achieved while maintaining the LWR performance that a resist upper layer film originally has. On the other hand, organotin compounds, which are considered as resist upper layer films, have poor heat resistance, and undergo rapid volume shrinkage during baking. Therefore, it is difficult to fill and planarize the steps of a substrate to be processed after high-temperature baking. The present inventors have considered that the bonds of a diol- or catechol-based compound, which can be bonded to a tin atom by a valency of 2 per molecule, are not easily cleaved at the time of baking, and therefore, heat resistance can be enhanced. The present inventors have further found out that by a plurality of such structures being contained in one molecule, the tin content can be increased while increasing the molecular weight, and it is possible to achieve a composition for forming a metal-containing film that exhibits further enhancement in heat resistance and excellent etching resistance. Thus, the present invention has been completed.

That is, the present invention is a compound for forming a metal-containing film, being a reaction product between a compound having two or more diol structures per molecule and a Sn compound, and being a monomolecular compound containing two or more Sn atoms per molecule.

Hereinafter, the present invention will be described in detail, but the present invention is not limited thereto. The recitations of numerical ranges by endpoints include all numbers subsumed within that range.

### <Compound for Forming Metal-Containing Film>

The inventive compound for forming a metal-containing film is a reaction product between a compound having two or more diol structures, including catechol structures, per molecule and a tin compound, and is a monomolecular compound containing two or more tin atoms per molecule. This compound can be contained in a composition for forming a metal-containing film that serves as a resist underlayer film material used in semiconductor manufacture.

In the present invention, a compound having a diol structure indicates a compound having two or more hydroxy groups (-OH) per molecule (i.e., polyol). Examples of such compounds include aliphatic diols and aromatic diols having two hydroxy groups per molecule, triols and tetraols, having three or more hydroxy groups per molecule, etc. The positions of the hydroxy group substituents in the molecules of the aliphatic hydrocarbon (linear, branched, or cyclic, and saturated or unsaturated), aromatic hydrocarbon, and the like, the hydrocarbon being substituted or unsubstituted and optionally having a heteroatom at any position, are not particularly limited, but preferable are compounds having a structure of 1,2-diol, which has hydroxy groups on two adjacent carbon atoms, and 1,3-diol, which has a hydroxy group on one carbon atom and a carbon atom at the β position of the carbon atom, and more preferable are compounds having a 1,2-diol structure.

The 1,2-diol structure also includes structures having hydroxyl groups on two adjacent carbon atoms of an aromatic ring.

Examples of compounds having a 1,2-diol structure include: alkanediols (having hydroxy groups on two adjacent carbon atoms) having 2 to 70 carbon atoms and optionally having a substituent; alicyclic diols (having hydroxy groups on two adjacent carbon atoms contained in the ring) having 3 to 70 carbon atoms and optionally having a substituent; catechol derivatives, such as catechol, 3-methylcatechol, 4-methylcatechol, and pyrogallol; heterocyclic compounds, such as N-benzoyl-3,4-dihydroxypyrrolidine, having hydroxy groups on two adjacent carbon atoms contained in the ring; etc.

Furthermore, the compound having the diol structure may be a compound containing a hydroxy group and a carboxy group (COOH), such as an α-hydroxycarboxylic acid, or may be a compound which is to have two or more hydroxy groups in a canonical structure, and examples of the latter include β-diketones such as acetylacetone.

Examples of compounds having a 1,3-diol structure include alkanediols having 3 to 70 carbon atoms, such as 1,3-propanediol, optionally having a substituent and so forth.

The compound of the present invention having the diol structure is a compound (complex) in which the diol is coordinated to the central metal Sn, and examples include compounds in which a 1,2-diol (ligand) forms a five-membered ring with the Sn. When an aromatic 1,2-diol, such as catechol and 2,3-naphthalenediol, is coordinated to a Sn atom to form a five-membered ring, a hard structure is formed.

Microscopically, such a compound can be bonded to the tin atom by two hydroxy groups contained in the catechol or diol, and when the bonds to the organic ligand are cleaved, Sn-O bonds in two places need to be cleaved at the same time, so that the tin-containing compound has better heat resistance than ordinary compounds having a monovalent ligand. Thus, it is possible to suppress volume shrinkage, which causes degradation in filling property, and therefore, it is possible to provide a resist underlayer film material excellent in film-formability and filling and planarizing properties even after baking at a high temperature. Macroscopically, since multiple tin atoms can be introduced per molecule, it is also possible to raise the tin content while increasing the molecular weight, and it is possible to provide a resist underlayer film material excellent in heat resistance and etching resistance.

The compound for forming a metal-containing film is preferably a compound represented by the following general formula (M-1) or (M-2).

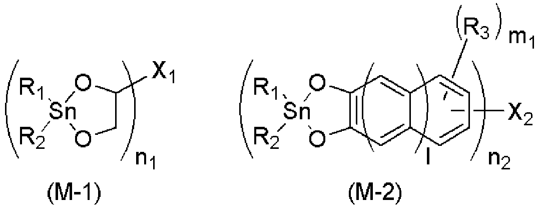

In the general formulae (M-1) and (M-2), R₁ and R₂ each independently represent a monovalent organic group or a halogen atom; X₁ represents an organic group having a valency of "n₁" selected from the group consisting of a substituted or unsubstituted linear alkyl group having 1 to 20 carbon atoms, a substituted or unsubstituted, branched or cyclic alkyl group having 3 to 70 carbon atoms, a substituted or unsubstituted aliphatic unsaturated hydrocarbon group having 2 to 20 carbon atoms and having one or more double bonds or triple bonds, optionally the alkyl groups and the aliphatic unsaturated hydrocarbon group having an ether group, a thioether group, an ester group, or an amide group, a substituted or unsubstituted aryl group having 6 to 30 carbon atoms, a substituted or unsubstituted arylalkyl group having 6 to 30 carbon atoms, a substituted or unsubstituted triazine ring, a substituted or unsubstituted isocyanuric group, and a substituted or unsubstituted glycoluril group; "n₁" represents an integer of 2 to 6; R₃ represents a substituent other than a hydrogen atom and each independently represents a substituted or unsubstituted alkyl group having 1 to 20 carbon atoms, a substituted or unsubstituted, branched or cyclic alkyl group having 3 to 20 carbon atoms, a substituted or unsubstituted aliphatic unsaturated hydrocarbon group having 2 to 20 carbon atoms and having one or more double bonds or triple bonds, a substituted or unsubstituted alkoxy group having 1 to 20 carbon atoms, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen atom; "l" represents an integer of 0 or 1; "m₁" represents an integer of 0 to 5; X₂ represents a single bond or a linking moiety, the linking moiety being a carbonyl group, an ether group, an ester group, an amide group, an organic group having a valency of "n₂" selected from the group consisting of a substituted or unsubstituted linear alkyl group having 1 to 20 carbon atoms, a substituted or unsubstituted, branched or cyclic alkyl group having 3 to 20 carbon atoms, a substituted or unsubstituted aliphatic unsaturated hydrocarbon group having 2 to 20 carbon atoms and having one or more double bonds or triple bonds, optionally the alkyl group and the aliphatic unsaturated hydrocarbon group having a ketone group, an ether group, an ester group, an amide group, an imine group, a lactone ring, or a sultone ring, a substituted or unsubstituted aryl group having 6 to 36 carbon atoms, a substituted or unsubstituted arylalkyl group having 6 to 36 carbon atoms, and a substituted or unsubstituted triazine ring, or an organic group having a valency of 2×n₂ selected from the group consisting of substituted or unsubstituted, saturated or unsaturated hydrocarbon groups having 2 to 20 carbon atoms and forming a cyclic structure together with the aromatic ring, optionally the hydrocarbon groups having an ether group; and "n₂" represents an integer of 2 to 4.

The present inventors have further studied earnestly and found out that a compound for forming a metal-containing film represented by the general formula (M-1) or (M-2) can ensure a sufficient molecular weight, so that rapid volume shrinkage during baking can be suppressed, and the compound has excellent film-formability, filling property, and planarizing property; and furthermore, the tin content can be increased, so that a compound for forming a metal-containing film having excellent etching resistance can be achieved.

The compound for forming a metal-containing film represented by the general formula (M-1) or (M-2) can guarantee sufficient molecular weight, and therefore, it is possible to suppress sudden volume shrinkage at the time of baking, so that the compound has excellent film-formability, filling property, and planarizing property. Furthermore, since it is also possible to increase the tin content, the compound for forming a metal-containing film can give a metal-containing film having excellent etching resistance.

In the general formulae (M-1) and (M-2), R₁ and R₂ each independently represent a monovalent organic group or a halogen atom, and from the viewpoints of the availability of raw materials and synthesis, preferably an alkyl group, an ester group, an alkoxy group, or a chlorine atom, and from the viewpoint of solvent solubility, R₁ and R₂ preferably have different structures in a single compound. Furthermore, considering thermal flowability, R₁ and R₂ are preferably a combination of an alkyl group and an ester group.

In the general formula (M-1), X₁ represents an organic group having a valency of "n₁" selected from the group consisting of a substituted or unsubstituted linear alkyl group having 1 to 20 carbon atoms, a substituted or unsubstituted, branched or cyclic alkyl group having 3 to 70 carbon atoms, a substituted or unsubstituted aliphatic unsaturated hydrocarbon group having 2 to 20 carbon atoms and having one or more double bonds or triple bonds, optionally the alkyl groups and the aliphatic unsaturated hydrocarbon group having an ether group, a thioether group, an ester group, or an amide group, a substituted or unsubstituted aryl group having 6 to 30 carbon atoms, a substituted or unsubstituted arylalkyl group having 6 to 30 carbon atoms, a substituted or unsubstituted triazine ring, a substituted or unsubstituted isocyanuric group, and a substituted or unsubstituted glycoluril group; and "n₁" represents an integer of 2 to 6. Specific examples of the general formula (M-1) include the following, but are not limited thereto.

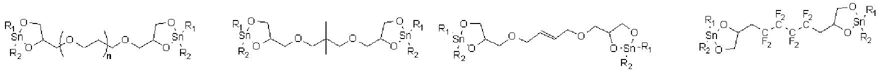

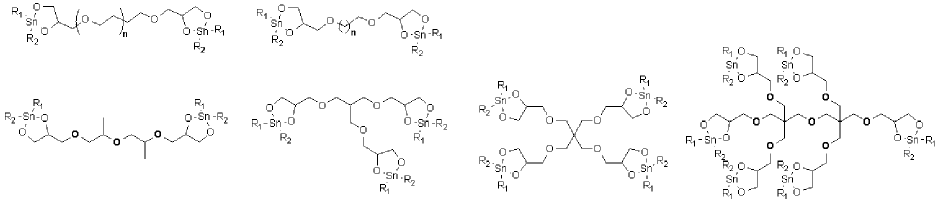

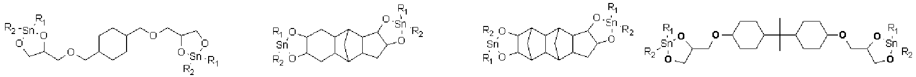

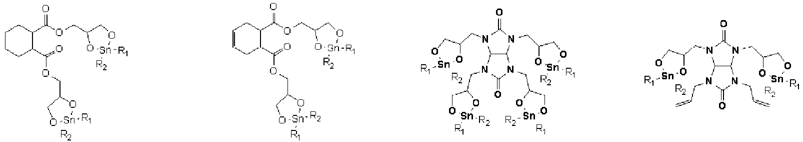

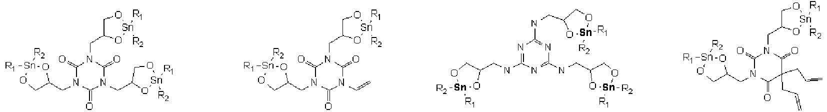

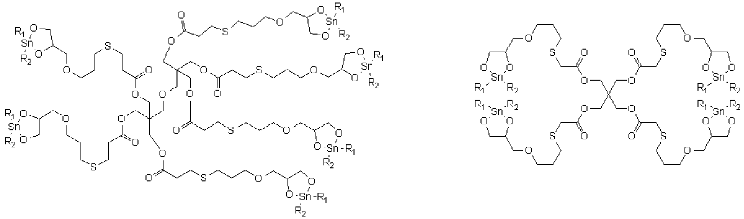

The "n" in the above formulae each independently represent an integer of 0 or more, and apply only in the above formulae.

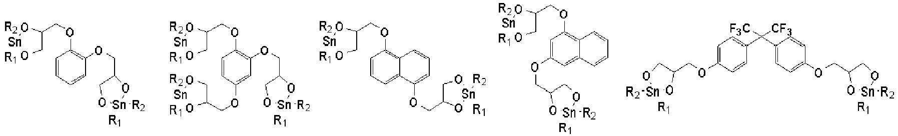

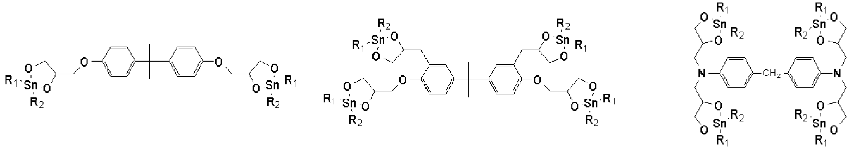

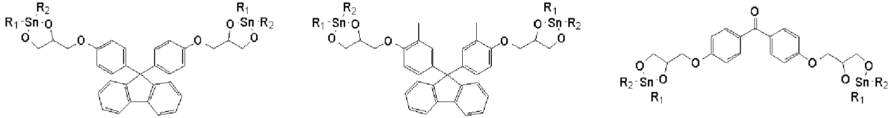

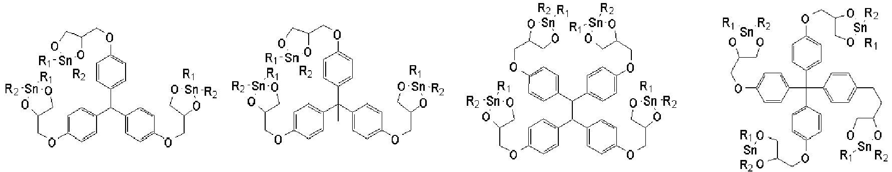

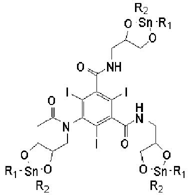

Specific examples of the R₃ in the general formula (M-2) include the following, but are not limited thereto. Incidentally, in the following formulae, "*" represents an attachment point to the aromatic ring.

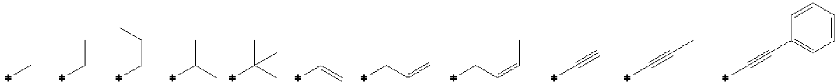

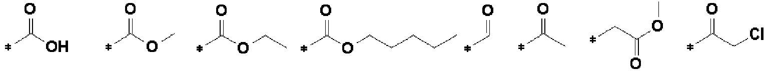

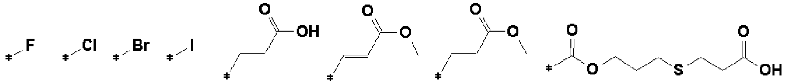

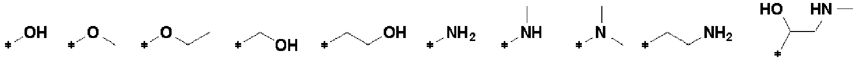

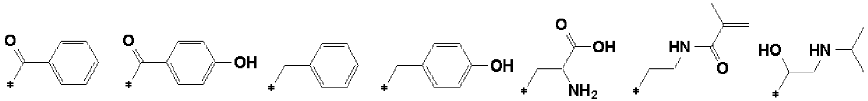

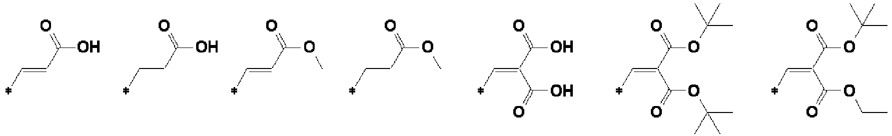

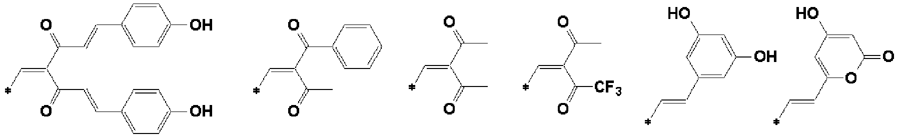

In the general formula (M-2), "l" represents an integer of 0 or 1, and from the viewpoint of increasing the Sn content, "l" is preferably 0.

In the general formula (M-2), X₂ represents a single bond or a linking moiety, the linking moiety being a carbonyl group, an ether group, an ester group, an amide group, an organic group having a valency of "n₂" selected from the group consisting of a substituted or unsubstituted linear alkyl group having 1 to 20 carbon atoms, a substituted or unsubstituted, branched or cyclic alkyl group having 3 to 20 carbon atoms, a substituted or unsubstituted aliphatic unsaturated hydrocarbon group having 2 to 20 carbon atoms and having one or more double bonds or triple bonds, optionally the alkyl group and the aliphatic unsaturated hydrocarbon group having a ketone group, an ether group, an ester group, an amide group, an imine group, a lactone ring, or a sultone ring, a substituted or unsubstituted aryl group having 6 to 36 carbon atoms, a substituted or unsubstituted arylalkyl group having 6 to 36 carbon atoms, and a substituted or unsubstituted triazine ring, or an organic group having a valency of 2×n₂, two times n₂, selected from the group consisting of substituted or unsubstituted, saturated or unsaturated hydrocarbon groups having 2 to 20 carbon atoms and forming a cyclic structure together with the aromatic ring, optionally the hydrocarbon groups having an ether group; and "n₂" represents an integer of 2 to 4. Specific examples of the general formula (M-2) include the following, but are not limited thereto.

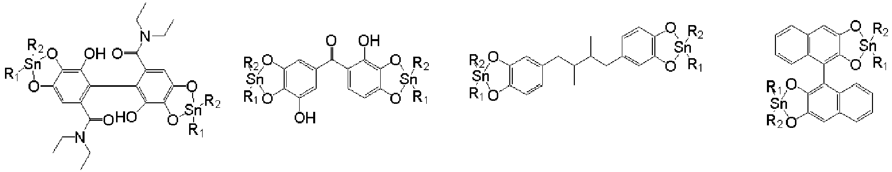

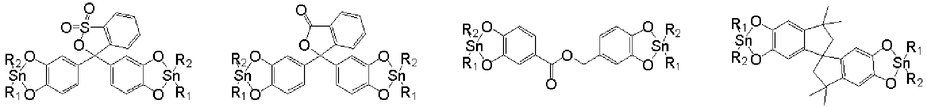

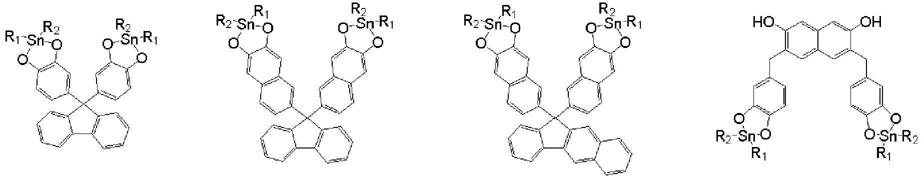

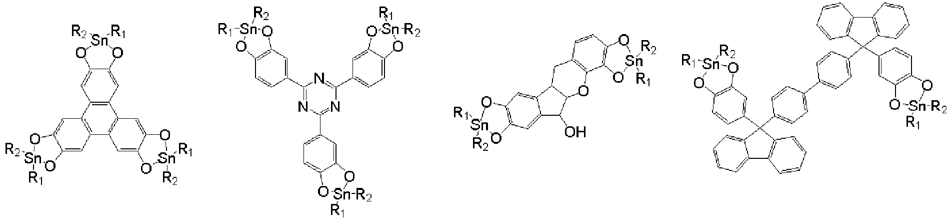

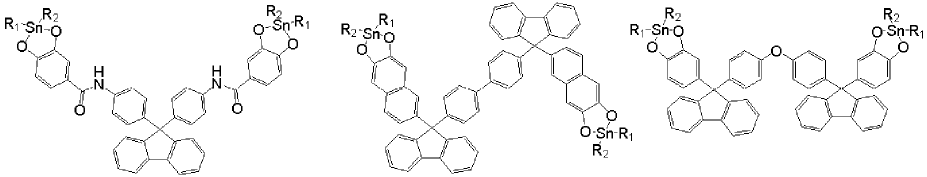

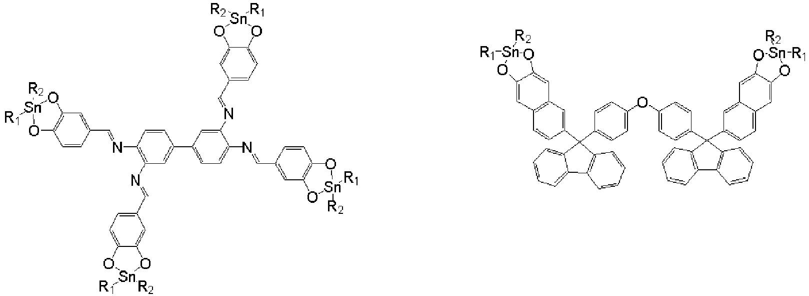

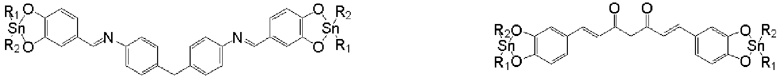

In the general formulae (M-1) and (M-2), R₁ is preferably a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, or a substituted or unsubstituted arylalkyl group having 7 to 31 carbon atoms. From the viewpoint of suppressing sublimation products, R₁ is more preferably an unsubstituted alkyl group having 1 to 20 carbon atoms, and from the availability of raw materials, particularly preferably an n-butyl group.

Such a compound for forming a metal-containing film contains a tin-alkyl bond in the compound, and therefore, the bond is cleaved at the time of baking, so that radicals are generated. Therefore, a crosslinking reaction originating from the radicals takes place, allowing excellent thermosetting property. Accordingly, it is possible to provide a resist underlayer film material excellent in film-formability, filling property, and planarizing property even after baking at a high temperature.

Furthermore, the R₂ in the general formulae (M-1) and (M-2) is preferably -OC(=O)R₂' (R₂' being a monovalent organic group), from the viewpoint of solvent solubility.

Such a compound for forming a metal-containing film is asymmetrical, and therefore, is excellent in solvent solubility, and is also excellent in thermal flowability, so that it is possible to provide a resist underlayer film excellent in planarizing property. In addition, -OC(=O)R₂' makes it possible to change the R₂' freely, so that further improvement of solubility and thermal flowability can be expected when a bulky structure is incorporated, and since it is also possible to provide a crosslinking structure, sublimation products can be suppressed, so that suppression of volume shrinkage, which induces degradation in filling property, can also be expected. Thus, it is possible to provide a resist underlayer film material excellent in film-formability and filling and planarizing properties even after high-temperature baking.

In the R₂, the R₂' preferably represents one of the following general formulae (A-1) to (A-4), the following general formula (2), or the following general formula (3) .

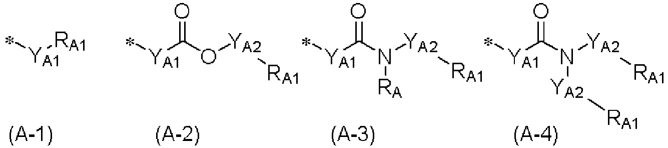

In the general formulae (A-1) to (A-4), Y_{A1} and Y_{A2} are each identical to or different from each other and represent a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R_{A} represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R_{A1} represents an organic group whose protecting group is to be removed by an action of an acid, heat, or both to generate one or more hydroxy groups or carboxyl groups, R_{A1} being represented by one of the following general formulae (1); and "*" represents an attachment point to the carbonyl group.

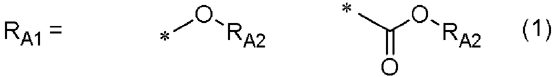

In the general formulae (1), R_{A2} represents an organic group whose protecting group is to be removed by an action of an acid, heat, or both; and "*" represents an attachment point to Y_{A1} or Y_{A2}.

In the general formulae (A-1) to (A-4), Y_{A1} and Y_{A2} are each identical to or different from each other and represent a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms. R_{A} represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms. R_{A1} represents an organic group whose protecting group is to be removed by an action of an acid, heat, or both to generate one or more hydroxy groups or carboxyl groups, R_{A1} being represented by one of the general formulae (1). In view of thermal flowability, (A-4) is preferable, and from the viewpoint of raising the tin content, (A-1) is preferable.

Examples of favorable structures of the Y_{A2} in the general formulae (A-2) to (A-4) include the following structures, but are not limited thereto. In the following formulae, "*ₐ" represents an attachment point to R_{A1}, and "*_{b}" represents the other attachment point.

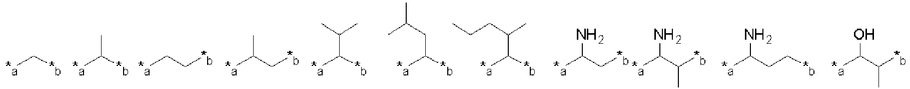

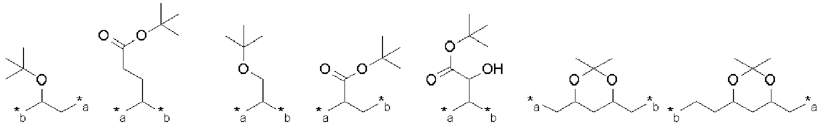

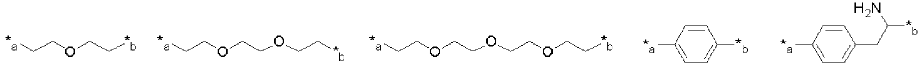

The R_{A} in the general formula (A-3) represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, and from the viewpoints of suppressing sublimation products and increasing the Sn content, preferably a hydrogen atom.

The R_{A2} in the general formula (1) represents an organic group whose heat/acid-labile group is to be removed by an action of an acid, heat, or both, preferably a tertiary hydrocarbyl group or a group that forms an acetal structure together with the adjacent oxygen atom, particularly preferably a tertiary hydrocarbyl group.

As the tertiary hydrocarbyl group, those having 4 to 20 carbon atoms are preferable, and from the viewpoints of suppressing sublimation products due to thermal decomposition products and the ease of acquiring raw materials, a tert-butyl group is particularly preferable. Specific examples include those shown below, but are not limited thereto. Incidentally, in the following formulae, "*" represents an attachment point to the oxygen atom.

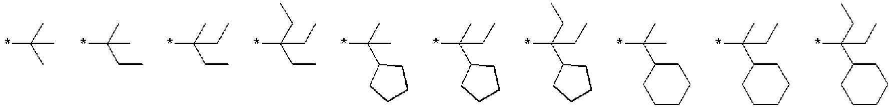

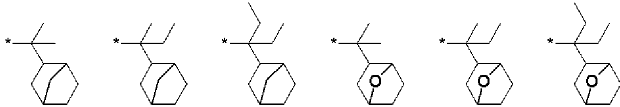

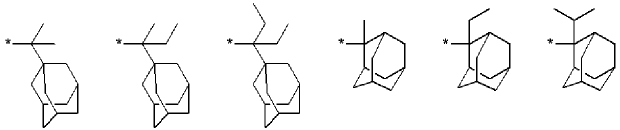

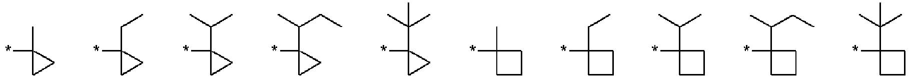

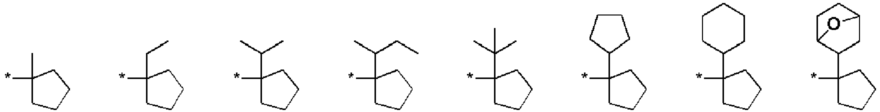

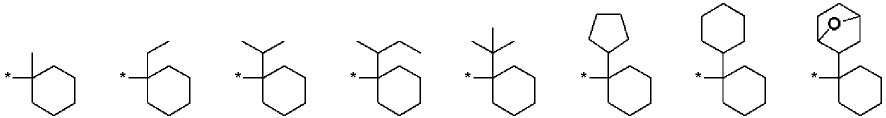

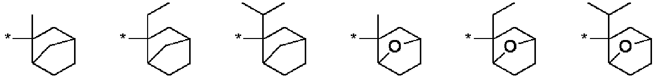

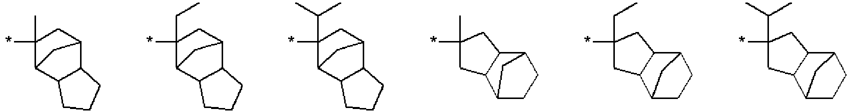

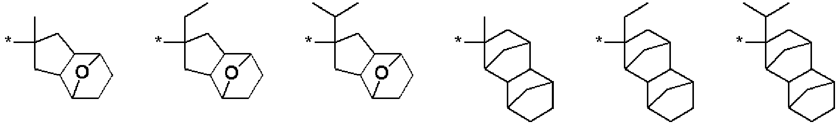

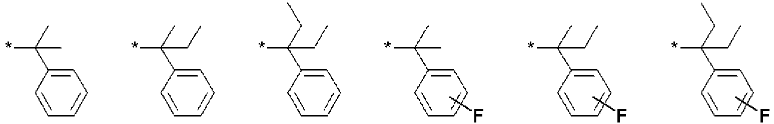

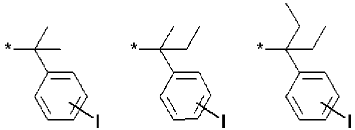

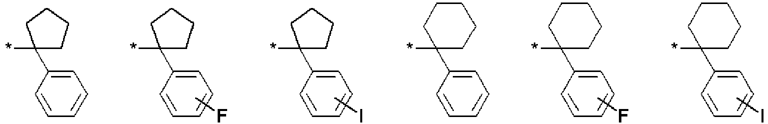

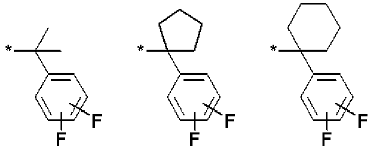

The group forming the acetal structure is not particularly limited as long as it is an organic group whose labile group is eliminated or cleaved by the action of an acid, heat, or both. Specific examples of the group forming the acetal structure include those shown below, but are not limited thereto. Incidentally, in the following formulae, "*" represents an attachment point to the oxygen atom.

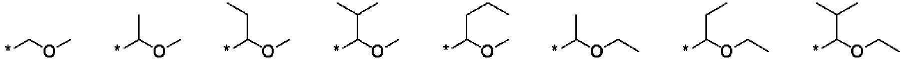

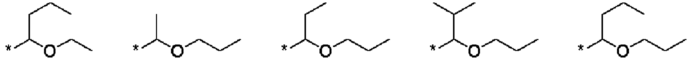

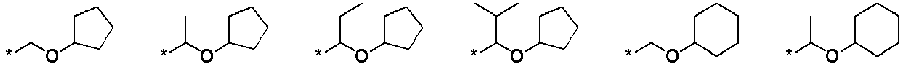

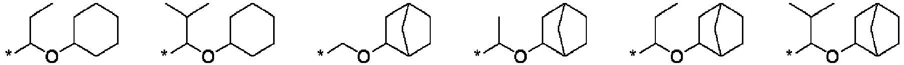

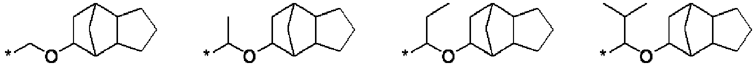

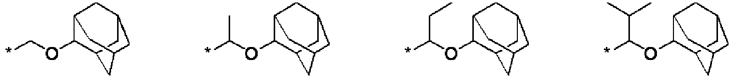

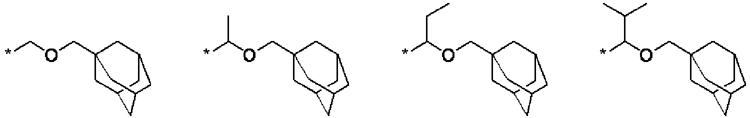

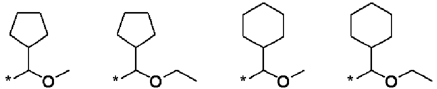

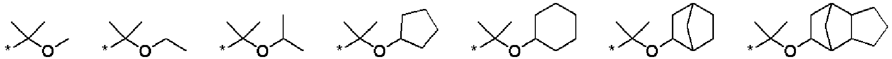

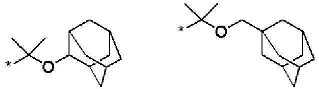

Such a compound for forming a metal-containing film is excellent in solvent solubility and thermal flowability. Furthermore, since a heat/acid-labile group is contained in the R_{A1}, when the compound is contained in a composition for forming a metal-containing film, the groups are removed during baking, so that the tin content increases. Thus, it is possible to form a metal-containing film having excellent dry etching resistance. Furthermore, the hydroxy groups or carboxyl groups generated by the removal easily react with the radicals that are generated by the cleavage of the tin-carbon bonds at the time of baking because of the presence of terminal OH or α-hydrogen, so that a crosslinking reaction occurs, and excellent thermosetting property can be provided. Therefore, volume shrinkage can be suppressed, and it is possible to provide a composition for forming a metal-containing film that is excellent in film-formability and planarizing and filling properties even after high-temperature baking.

In a metal-containing film formed by using an organotin compound, the organic groups bonded to the Sn atoms via a C atom generate radicals while being dissociated during baking, and the generated radicals form -Sn-O-Sn- bonds, initiating a condensation polymerization reaction. Thus, the curing of the metal-containing film progresses. On the other hand, since organic groups are removed at the same time as the reaction, great film shrinkage occurs during baking. However, the compound has a heat/acid-labile group on an end, and the heat/acid-labile group is removed during baking to generate a hydroxy group or a carboxyl group. The OH or α-hydrogen on the end of the hydroxy group or carboxyl group easily react with the radicals, and a crosslinking reaction occurs as in the following reaction formula. Since at least one of such an organic group is contained, it is possible to prevent the whole of the organic group from undergoing thermal decomposition and sublimation, and excellent thermal flowability is provided. Therefore, it is possible to provide a composition for forming a metal-containing film excellent in filling property.

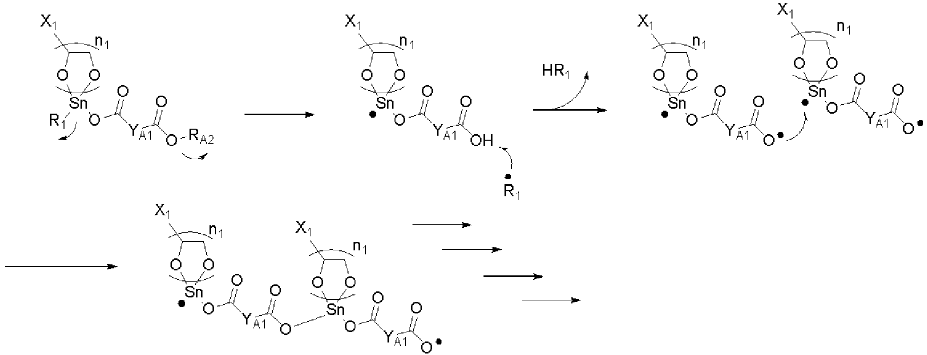

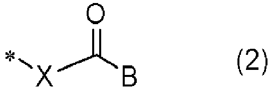

In the general formula (2), X represents a divalent organic group having 1 to 31 carbon atoms; B represents the following general formula (B); and "*" represents an attachment point to the carbonyl group.

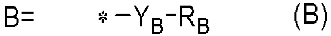

In the general formula (B), Y_{B} represents a substituted or unsubstituted saturated divalent aliphatic hydrocarbon group having 1 to 20 carbon atoms, a substituted or unsubstituted unsaturated divalent aliphatic hydrocarbon group having 2 to 20 carbon atoms, a substituted or unsubstituted divalent aryl group having 6 to 30 carbon atoms, or a substituted or unsubstituted divalent arylalkyl group having 7 to 31 carbon atoms, optionally Y_{B} being bonded to an adjacent group via an oxygen atom or an NH group; R_{B} represents a hydroxy group or a structure represented by one of the following general formulae (B-1) to (B-3); and "*" represents an attachment point to the carbonyl group.

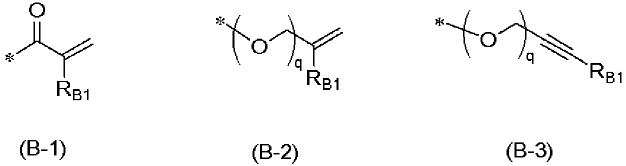

In the general formulae (B-1) to (B-3), R_{B1} represents a hydrogen atom or a monovalent organic group having 1 to 10 carbon atoms; "q" represents 0 or 1; and "*" represents an attachment point to Y_{B}.

In the general formula (2), X represents a divalent organic group having 1 to 31 carbon atoms; B represents the general formula (B); and "*" represents an attachment point to the carbonyl group. In the general formula (B), it is preferable that Y_{B} represents a substituted or unsubstituted saturated divalent aliphatic hydrocarbon group having 1 to 20 carbon atoms, a substituted or unsubstituted unsaturated divalent aliphatic hydrocarbon group having 2 to 20 carbon atoms, a substituted or unsubstituted divalent aryl group having 6 to 30 carbon atoms, or a substituted or unsubstituted divalent arylalkyl group having 7 to 31 carbon atoms, optionally Y_{B} being bonded to an adjacent group via an oxygen atom or an NH group; and R_{B} represents a hydroxy group or a structure represented by one of the general formulae (B-1) to (B-3). In the general formulae (B-1) to (B-3), R_{B1} represents a hydrogen atom or a monovalent organic group having 1 to 10 carbon atoms, and from the viewpoint of suppressing sublimation products, preferably a hydrogen atom.

Examples of preferable structures of the general formula (B) include the following structures, but are not limited thereto. Incidentally, in the following formulae, "*" represents an attachment point to the carbonyl group. The following examples also represent possible structural isomers.

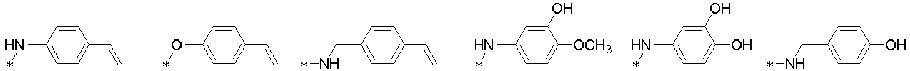

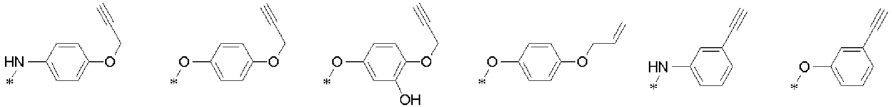

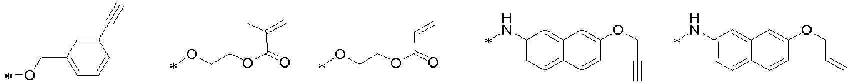

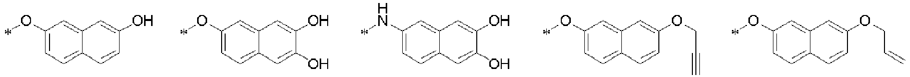

Such a compound for forming a metal-containing film is excellent in solvent solubility and thermal flowability. Furthermore, since a hydroxy group or an unsaturated bond is contained in the R_{B}, when the compound is contained in a composition for forming a metal-containing film, the hydroxy group or unsaturated bond causes a crosslinking reaction during baking, so that excellent thermosetting property is provided, and furthermore, by the hydroxy group or unsaturated bond also reacting with the radicals generated by the cleavage of the tin-carbon bonds, the crosslinking reaction is promoted, and excellent thermosetting property is provided. Thus, volume shrinkage can be suppressed, and it is possible to provide a composition for forming a metal-containing film excellent in film-formability and planarizing and filling properties even after high-temperature baking. 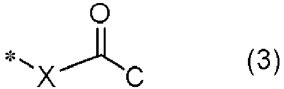 In the general formula (3), X represents a divalent organic group having 1 to 31 carbon atoms; C represents one of the following general formulae (C-1) to (C-4); and "*" represents an attachment point to the carbonyl group.

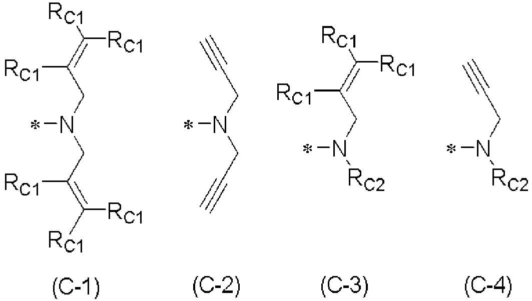

In the general formulae (C-1) and (C-3), R_{C1}s each independently represent a hydrogen atom or a methyl group and are identical to or different from each other in a single formula. In (C-3) and (C-4), R_{C2} represents a hydrogen atom, a substituted or unsubstituted, saturated or unsaturated monovalent aliphatic hydrocarbon group having 1 to 20 carbon atoms, a substituted or unsubstituted aryl group having 6 to 30 carbon atoms, or a substituted or unsubstituted arylalkyl group having 7 to 31 carbon atoms. "*" represents an attachment point to the carbonyl group.

In the general formula (3), X represents a divalent organic group having 1 to 31 carbon atoms, and specific examples include substituted or unsubstituted saturated divalent hydrocarbon groups having 1 to 20 carbon atoms, substituted or unsubstituted unsaturated divalent hydrocarbon groups having 2 to 20 carbon atoms, substituted or unsubstituted aryl groups having 6 to 30 carbon atoms, substituted or unsubstituted arylalkyl groups having 7 to 31 carbon atoms, etc. C represents one of the general formulae (C-1) to (C-4). In (C-1) and (C-3), R_{C1} is preferably a methyl group from the viewpoint of thermal flowability, and is preferably a hydrogen atom from the viewpoint of curability. In addition, the R_{C2} in (C-3) and (C-4) is preferably a hydrogen atom from the viewpoint of suppressing sublimation products, and is preferably one of the above-described structures other than a hydrogen atom from the viewpoint of thermal flowability.

Examples of favorable structures of the R_{C2} in the general formulae (C-1) to (C-4) include the following structures, but are not limited thereto. Incidentally, in the following formulae, "*" represents an attachment point to the nitrogen atom.

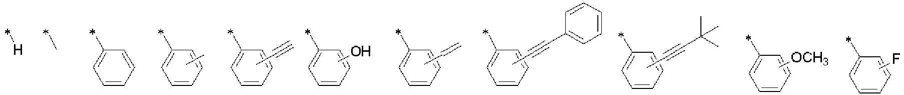

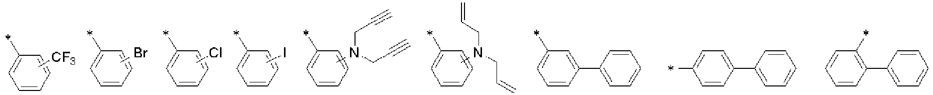

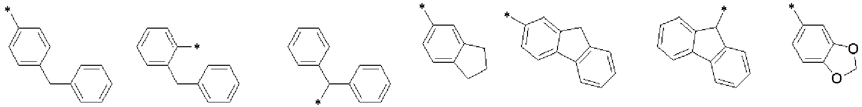

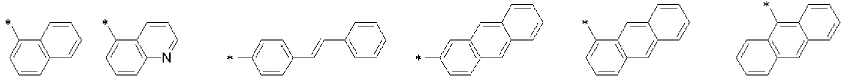

A compound for forming a metal-containing film having such a structure contains an organic group represented by the general formula (3), and therefore, is excellent in solvent solubility and heat resistance, and furthermore, contains one of the structures represented by the general formulae (C-1) to (C-4) on an end, and therefore, has a high density of crosslinking groups, so that rapid volume shrinkage during baking can be reduced. Moreover, the compound also has excellent thermal flowability, and therefore, it is possible to provide a composition for forming a metal-containing film excellent in filling and planarizing properties.

Examples of favorable structures of the Y_{A1} in the general formulae (A-1) to (A-4), the X in the general formula (2), or the X in the general formula (3) include the following structures, but are not limited thereto. Incidentally, in the following formulae, "*" represents an attachment point to the carbon atom of the carbonyl group or the "*" in the formulae (A-1) to (A-4), (2), or (3) .

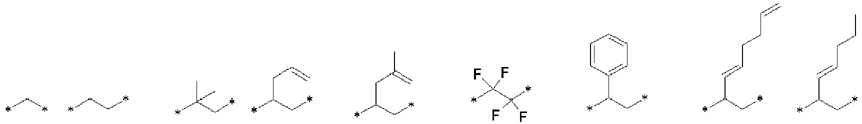

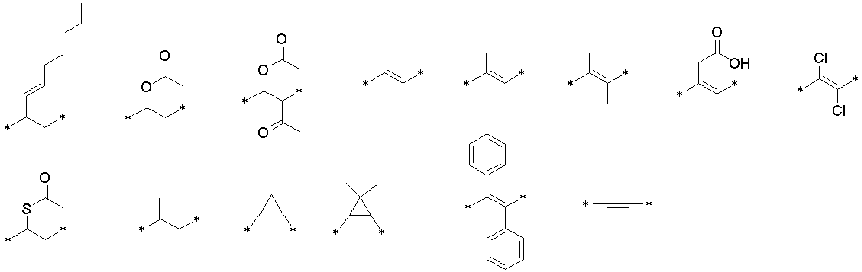

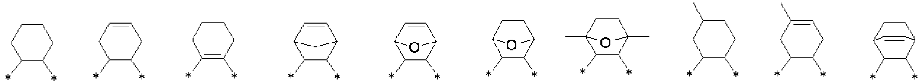

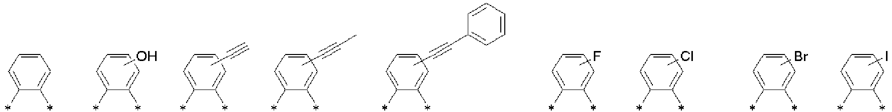

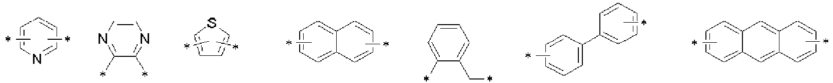

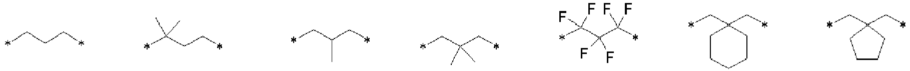

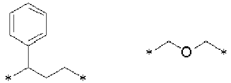

The Y_{A1} in the general formulae (A-1) to (A-4), the X in the general formula (2), or the X in the general formula (3) is preferably a substituted or unsubstituted unsaturated divalent hydrocarbon group having 2 to 20 carbon atoms.

When the Y_{A1} in the general formulae (A-1) to (A-4), the X in the general formula (2), or the X in the general formula (3) is such an unsaturated divalent hydrocarbon group, the thermosetting property of the compound for forming a metal-containing film can be further improved.

Furthermore, the Y_{A1} in the general formulae (A-1) to (A-4), the X in the general formula (2), or the X in the general formula (3) can be one of the following general formulae (4).

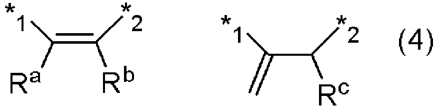

In the general formulae (4), R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, the substitution positions of "*1" and "*2" optionally being reversed.

A carboxylic acid raw material containing one of the general formulae (4) can be synthesized by ring-opening an acid anhydride, and in this event, when an asymmetrical carboxylic anhydride is ring-opened, a mixture of two types is obtained, and therefore, the above-described bonding form is obtained. By such isomers being present, crystallinity can be suppressed, and improvement in planarizing property, achieved by improvement in solvent solubility and improvement in thermal flowability, can be expected.

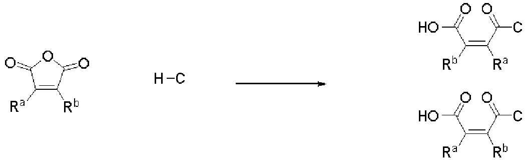

In the general formulae (4), R^{a}, R^{b}, and R^{c} each represent a hydrogen atom or a monovalent organic group having 1 to 20 carbon atoms, R^{a} and R^{b} optionally being bonded to each other to form a cyclic substituent. From the viewpoint of suppressing sublimation products, a hydrogen atom is particularly preferable.

In the general formula (M-2), "m₁" is preferably 0 or 1 from the viewpoint of increasing the tin content, and the R₃ when "m₁" is 1 is preferably a hydroxy group from the viewpoint of curability.

When the "m₁" in the general formula (M-2) is 0 or 1, the tin content is high, so that excellent etching resistance can be expected, and when the R₃ when "m₁" is 1 is a hydroxy group, radical cleavage of tin-carbon bonds occurs at the time of baking, but hydroxy groups react easily with radicals, and therefore, curability can be enhanced. Therefore, it is possible to provide a composition for forming a metal-containing film excellent in film-formability, filling property, and etching resistance even after high-temperature baking.

The compound for forming a metal-containing film preferably satisfies 1.00 ≤ Mw/Mn ≤ 1.50, where Mw is a weight-average molecular weight and Mn is a number-average molecular weight measured by gel permeation chromatography in terms of polystyrene.

From the definition, Mw/Mn is 1.00 when the compound is a monomolecular compound. However, for reasons of separability in gel permeation chromatography, the measured value exceeds 1.00 in some cases. Generally, it is extremely difficult to bring Mw/Mn close to 1.00 in a polymer having a repeating unit unless a special polymerization method is used, there is a molecular weight distribution, and Mw/Mn becomes a value greater than 1. In the present invention, 1.00 ≤ Mw/Mn ≤ 1.50 has been defined as an index indicating monomerism in order to distinguish between a monomolecular compound and a polymer.

A compound for forming a metal-containing film having a dispersity within such a range can be guaranteed to be a monomolecular compound and has even better thermal flowability, and therefore, when the compound is contained in a composition for forming a metal-containing film, it is possible to form a resist underlayer film that can not only fill favorably a fine structure formed on a substrate but can also achieve flatness across the entire substrate.

### <Composition for Forming Metal-Containing Film>

Furthermore, the present invention can provide a composition for forming a metal-containing film, the composition functioning as a resist underlayer film material used in manufacturing a semiconductor, the composition containing: (a) the inventive compound for forming a metal-containing film; and (b) an organic solvent.

Such a composition for forming a metal-containing film contains an organotin compound having excellent heat resistance and thermal flowability, and therefore, makes it possible to provide a resist underlayer film material having better dry etching resistance than conventional organic underlayer film materials and also having both high filling property and high planarizing property.

In the following, the components contained in the inventive composition for forming a metal-containing film other than the compound (a) for forming a metal-containing film will be described.

### <(b) Organic Solvent>

The organic solvent (b) usable in the inventive composition for forming a metal-containing film is not particularly limited as long as the solvent can dissolve or disperse the compound (a) for forming a metal-containing film, (c) a crosslinking agent, (d) a surfactant, (e) a flowability accelerator, (f) an acid generator, other additives, etc.

Specifically, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

### (High-Boiling-Point Solvent)

In the composition of the present invention for forming a metal-containing film (resist underlayer film), the organic solvent (b) may be a mixture of one or more kinds of organic solvent having a boiling point (the value at 1 atmosphere (1013 hPa)) of lower than 180°C and one or more kinds of organic solvent having a boiling point of 180°C or higher (a high-boiling-point solvent).

The high-boiling-point solvent is not particularly limited to hydrocarbons, alcohols, ketones, esters, ethers, or chlorine-based solvents as long as the solvent is capable of dissolving or dispersing the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent may be selected suitably from the solvents above, for example, depending on the temperature at which the composition of the present invention for forming a resist underlayer film is heat-treated, etc. The boiling point of the high-boiling-point solvent is preferably 180°C to 300°C, further preferably 200°C to 300°C. It is considered that when the boiling point is as described, sufficient thermal flowability can be achieved at the time of film formation, since there is no risk of excessive evaporation rate at the baking (heating). Thus, it is possible to form a resist underlayer film excellent in filling and planarizing properties. Moreover, a solvent having such a boiling point does not remain in the film without evaporating even after the baking. Therefore, there is no risk of the solvent adversely affecting the physical properties, such as etching resistance, of the film.

The organic solvent is preferably contained in an amount of 200 to 10,000 parts by mass, more preferably 250 to 5,000 parts by mass based on 100 parts by mass of the compound (a) for forming a metal-containing film.

Furthermore, when the high-boiling-point solvent is used, the contained amount is preferably 1 to 30 parts by mass per 100 parts by mass of the organic solvent having a boiling point lower than 180°C. When the contained amount is as described, sufficient thermal flowability can be imparted at the time of baking, so that the solvent does not remain in the film and cause degradation in the physical properties, such as etching resistance, of the film. Therefore, such an amount is preferable.

### <Composition for Forming Resist Underlayer Film>

The above-described composition is a composition for forming a metal-containing film that is usable as a resist underlayer film used in multilayer resist methods, and can further contain one or more of (c) a crosslinking agent, (d) a surfactant, (e) a flowability accelerator, and (f) an acid generator.

In the following, the components contained in the composition of the present invention for forming a resist underlayer film other than the compound (a) for forming a metal-containing film and the organic solvent (b) will be described.

### [(c) Crosslinking Agent]

To increase the denseness of the film and further inhibit intermixing with the resist upper layer film, the composition of the present invention for forming a resist underlayer film may also contain a crosslinking agent (c). The crosslinking agent is not particularly limited, and various known crosslinking agents can be widely used. Examples include melamine-based crosslinking agents, acrylate-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, phenol-based crosslinking agents (e.g. polynuclear phenol-based crosslinking agents as methylol- or alkoxymethyl-modified) epoxy-based crosslinking agents, and oxetane-based crosslinking agents. The crosslinking agent (c) is preferably contained in an amount of 5 to 50 parts by mass, more preferably 10 to 40 parts by mass relative to 100 parts by mass of the compound (a) for forming a metal-containing film.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the acrylate-based crosslinking agents include dipentaerythritol hexaacrylate.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate] .

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the polynuclear phenol-based crosslinking agents include compounds represented by the following general formula (XL-1).

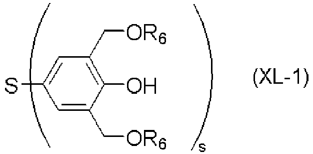

In the formula, S represents a single bond or an s-valent hydrocarbon group having 1 to 20 carbon atoms. R₆ represents a hydrogen atom or an alkyl group having 1 to 20 carbon atoms. "s" represents an integer of 1 to 5.

S represents a single bond or a hydrocarbon group having a valency of "s" and having 1 to 20 carbon atoms. "s" represents an integer of 1 to 5, more preferably 2 or 3. Specific examples of S include groups obtained by removing "s" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R₆ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. Among these, a hydrogen atom or a methyl group is preferable.

Specific examples of the compounds represented by the general formula (XL-1) include the following compounds. Among these, triphenolmethane, triphenolethane, 1,1,1,-tris(4-hydroxyphenyl)ethane, and a hexamethoxymethylated derivative of tris(4-hydroxyphenyl)-1-ethyl-4-isopropylbenzene are preferable from the viewpoint of improving the curability and film thickness uniformity of the organic film. R₆ is as defined above.

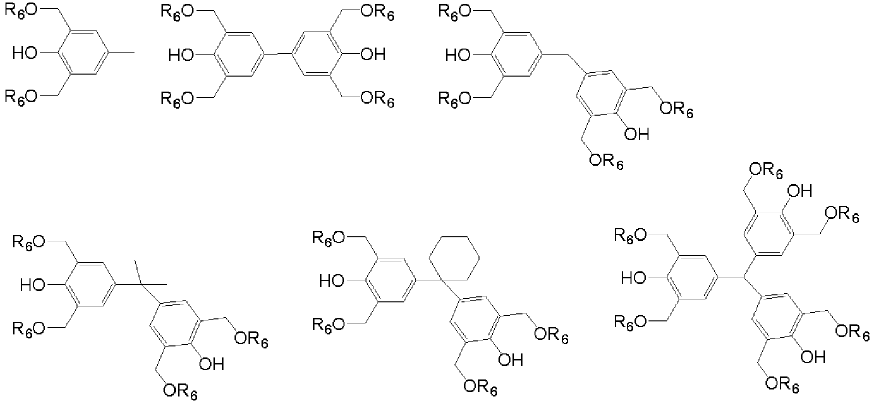

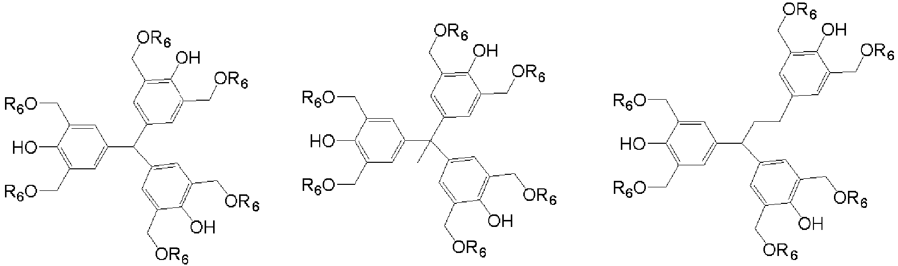

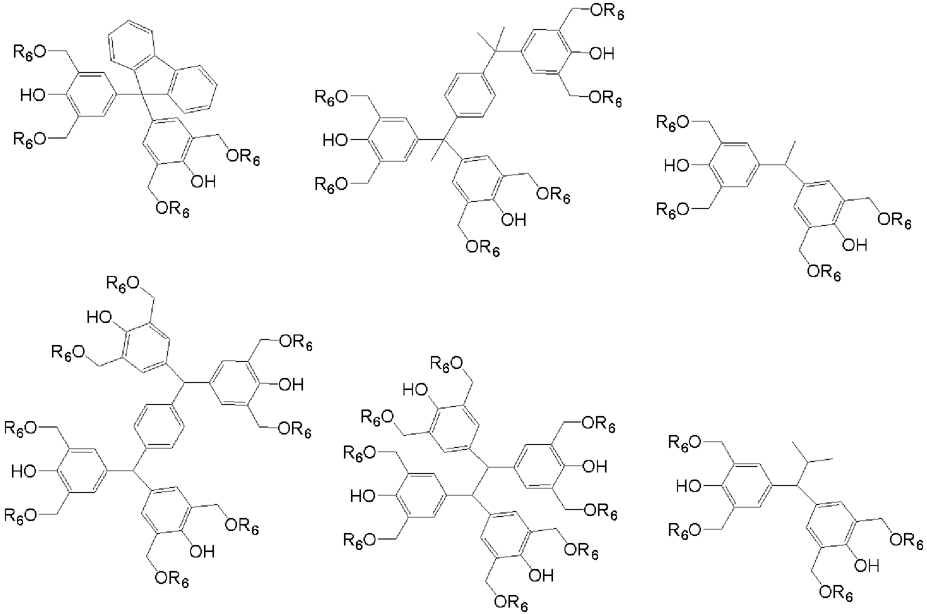

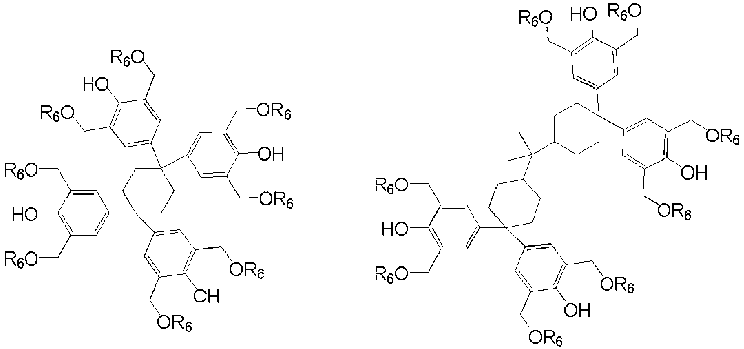

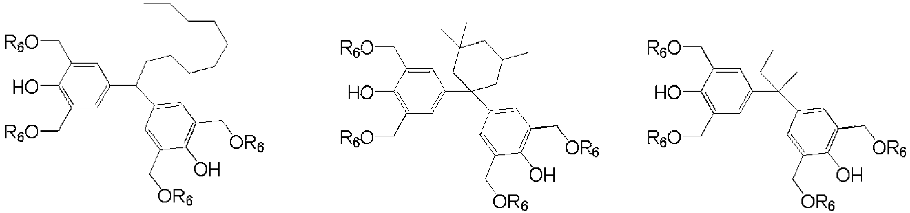

Examples of epoxy-based crosslinking agents and oxetane-based crosslinking agents include monomolecular types and polymer types, and specific examples of monomolecular types include the following, but are not limited thereto.

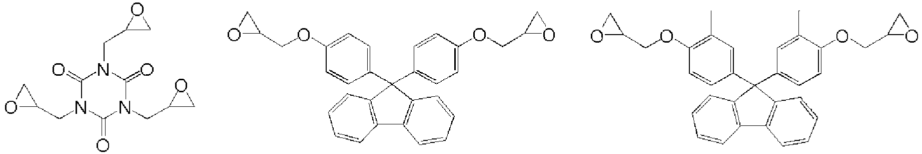

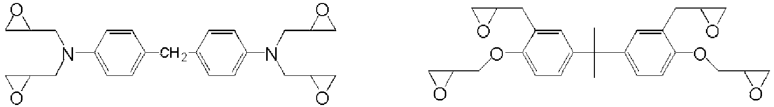

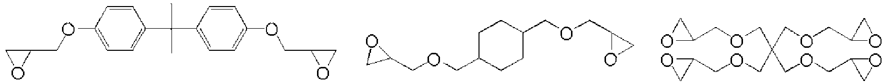

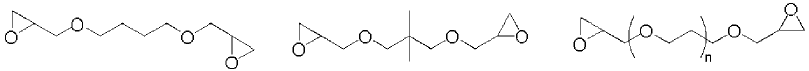

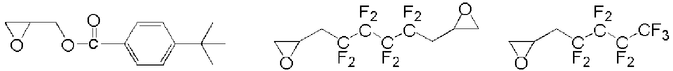

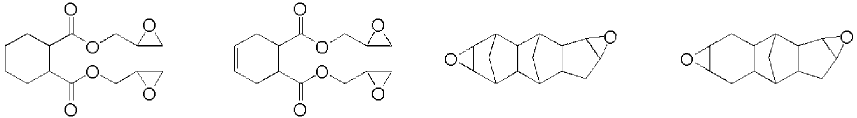

The above compounds can be purchased, but an epoxy-based crosslinking agent or an oxetane-based crosslinking agent can also be obtained by allowing a reaction between a hydroxy group and epibromohydrin, 3-bromomethyloxetane, or the like as in the following formula. In the following formula, R represents a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms. In addition, it is also possible to leave some hydroxy groups and not allow all the hydroxy groups to react. In this event, the sum of the number of epoxy groups and the number of oxetane groups is preferably greater than the number of hydroxy groups, and more preferably, the sum of the epoxy groups and the oxetane groups is greater than twice the number of hydroxy groups. Furthermore, these compounds are preferably contained in an amount of 5 to 50 parts by mass, more preferably 10 to 40 parts by mass based on 100 parts by mass of the compound (a) for forming a metal-containing film.

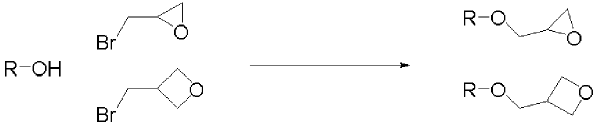

Specific examples of compounds having a hydroxy group usable in the above-described reaction include the following, but are not limited thereto.

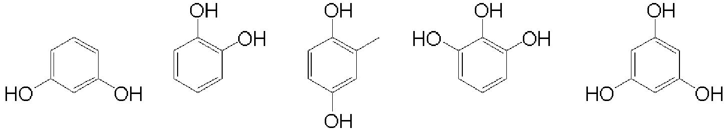

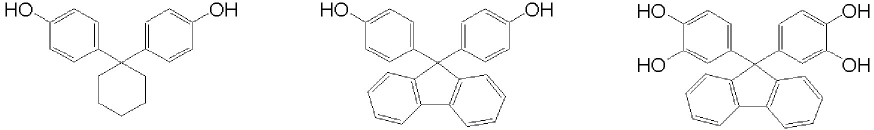

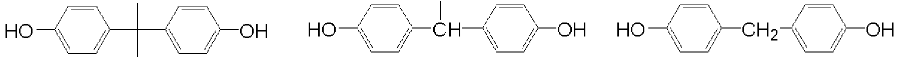

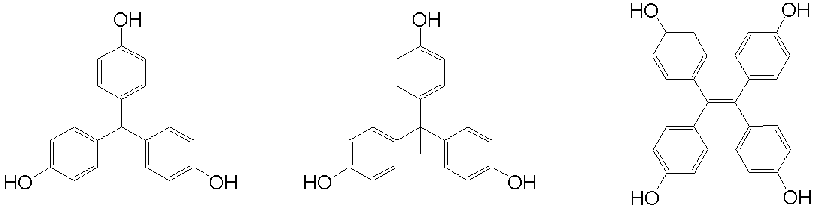

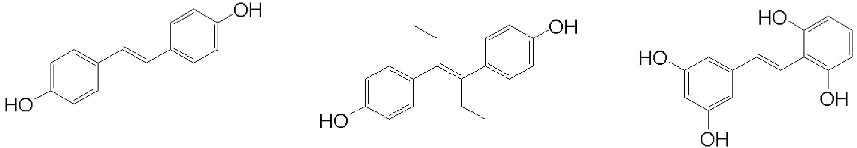

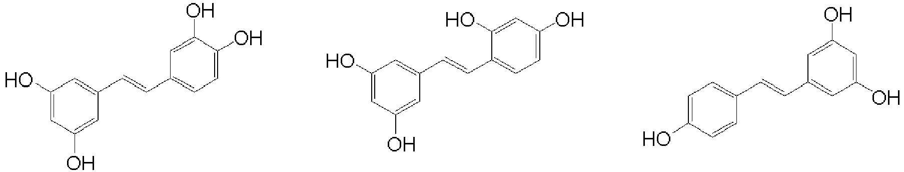

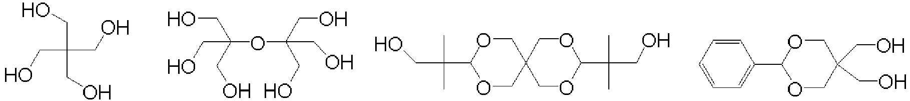

Meanwhile, specific examples of polymer types include polymers having a repeating unit represented by the following general formula (XL-2) and (XL-3) at a molar fraction of 20% or more. When the total of the molar fractions of the structural units represented by the general formulae (XL-2) and (XL-3) does not reach 100%, as the other structural units, it is possible to use a combination of any structural units derived from α,β-unsaturated carboxylic esters, such as other acrylates, other methacrylates, other acrylamides, other methacrylamides, crotonates, maleates, and itaconates; α,β-unsaturated carboxylic acids, such as methacrylic acid, acrylic acid, maleic acid, and itaconic acid; acrylonitrile; methacrylonitrile; α,β-unsaturated lactones, such as 5,5-dimethyl-3-methylene-2-oxotetrahydrofuran; cyclic olefins, such as norbornene derivatives and tetracyclo [4.4.0.1^{2,5}.1^{7,10}] dodecene derivatives; α,β-unsaturated carboxylic anhydrides, such as maleic anhydride and itaconic anhydride; allyl ethers; vinyl ethers; vinyl esters; and vinyl silanes. It is preferable that these polymers have a weight-average molecular weight of 1,000 to 20,000 and have a GPC dispersity of 2.0 or less. Furthermore, these compounds are preferably contained in an amount of 5 to 50 parts by mass, more preferably 10 to 40 parts by mass based on 100 parts by mass of the compound (a) for forming a metal-containing film. 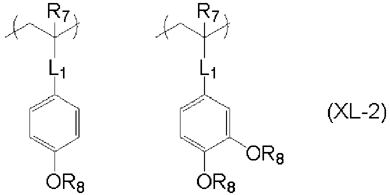 In the formulae, R₇ represents a hydrogen atom or a methyl group; R₈ represents a hydrogen atom or a group selected from the following formulae (2-1) to (2-3); L₁ represents a single bond or a divalent organic group containing -C(=O)O-, -C(=O)NH-, or -C(=O)NCH₃-.

In the R₈ in the general formulae (XL-2), the number of epoxy and oxetane groups is preferably greater than the number of hydroxy groups, more preferably, the number of epoxy and oxetane groups is greater than twice the number of hydroxy groups from the viewpoint of curability.

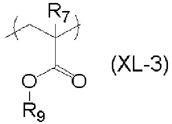

In the formula, R₇ represents a hydrogen atom or a methyl group; and R₉ represents a group selected from the following formulae (2-1) to (2-3).

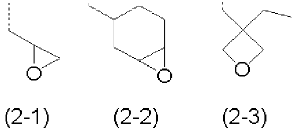

In the formulae, a broken line represents an attachment point.

### <(d) Surfactant>

A surfactant (d) may be contained in the composition of the present invention for forming a resist underlayer film in order to improve coating property in spin-coating. Examples of the surfactant include those disclosed in paragraphs [0142] to [0147] of JP2009-269953A. When the surfactant is contained, the contained amount is preferably 0.01 to 10 parts by mass, more preferably 0.05 to 5 parts by mass per 100 parts by mass of the compound (a) for forming a metal-containing film.

### <(e) Flowability Accelerator>

Another compound or polymer may be further blended in the composition of the present invention for forming a resist underlayer film. The flowability accelerator is mixed with the inventive compound for forming a metal-containing film and serves to improve the film-formability by spin-coating and the filling property for a stepped substrate. Furthermore, as the flowability accelerator, a material having a high density of carbon atoms and high etching resistance is preferable.

Examples of such a material include novolak resins of phenol, o-cresol, m-cresol, p-cresol, 2,3-dimethyl phenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluorene-9-ylidene)bisphenol, 2,2'-dimethyl-4,4'-(9H-fluorene-9-ylidene)bisphenol, 2,2'-diallyl-4,4'-(9H-fluorene-9-ylidene)bisphenol, 2,2'-difluoro-4,4'-(9H-fluorene-9-ylidene)bisphenol, 2,2'-diphenyl-4,4'-(9H-fluorene-9-ylidene)bisphenol, 2,2'-dimethoxy-4,4'-(9H-fluorene-9-ylidene)bisphenol, 2,3,2',3'-tetrahydro-(1,1')-spirobiindene-6,6'-diol, 3,3,3',3'-tetramethyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6, 6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, 7-methoxy-2-naphthol, dihydroxynaphthalene, such as 1,5-dihydroxynaphthalene, 1,7-dihydroxynaphthalene, and 2,6-dihydroxynaphthalene, methyl-3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, or limonene; polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth)acrylate, and copolymers thereof. In addition, the composition may contain a naphthol dicyclopentadiene copolymer disclosed in JP2004-205685A, a fluorene bisphenol novolak resin disclosed in JP2005-128509A, an acenaphthylene copolymer disclosed in JP2005-250434A, fullerene having a phenolic group disclosed in JP2006-227391A, a bisphenol compound and a novolak resin thereof disclosed in JP2006-293298A, a novolak resin of an adamantane phenol compound disclosed in JP2006-285095A, a bisnaphthol compound and a novolak resin thereof disclosed in JP2010-122656A, a fluorene compound disclosed in JP2017-119671A, a fullerene resin compound disclosed in JP2008-158002A, and the like. The flowability accelerator is preferably contained in an amount of 0.001 to 100 parts by mass, more preferably 0.01 to 50 parts by mass based on 100 parts by mass of the inventive compound for forming a metal-containing film.

In addition, in the composition of the present invention for forming a resist underlayer film, it is preferable to use, as an additive for imparting filling and planarizing properties, for example, a liquid additive having a polyethylene glycol or polypropylene glycol structure, or a thermo-decomposable polymer having a weight reduction rate of 40% by mass or more on heating from 30°C to 250°C and a weight-average molecular weight of 300 to 200,000. This thermo-decomposable polymer preferably contains a repeating unit having an acetal structure represented by the following general formula (DP1) or (DP1a). 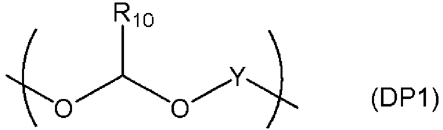 In the formula, R₁₀ represents a hydrogen atom or a substituted or unsubstituted, saturated or unsaturated monovalent organic group having 1 to 30 carbon atoms. Y represents a saturated or unsaturated divalent organic group having 2 to 30 carbon atoms. 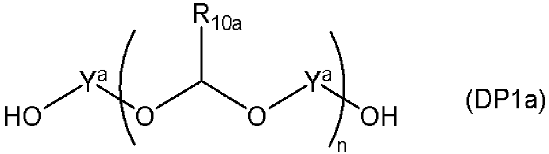 In the formula, R₁₀ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

### <(f) Acid Generator>

An acid generator (f) may be contained in the composition of the present invention for forming a resist underlayer film in order to promote the elimination reaction further. The acid generator (f) can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator can be used, or two or more kinds can be used in combination. When an acid generator is contained, the contained amount is preferably 0.05 to 50 parts by mass, more preferably 0.1 to 10 parts by mass relative to 100 parts by mass of the compound (a) for forming a metal-containing film.

### <Method for Forming Resist Underlayer Film>

The present invention provides a method of forming, by using the above-described composition for forming a metal-containing film, a resist underlayer film of a multilayer resist film used in lithography or a filling film that serves as a planarizing film for the manufacture of semiconductor.

In the method for forming a resist underlayer film by using the inventive composition for forming a metal-containing film, the substrate to be processed is coated with the above-described composition for forming a metal-containing film by a spin-coating method or the like. Using the spin-coating method or the like ensures a desirable filling property. After spin-coating, baking (heating) is performed so as to evaporate the solvent and promote a crosslinking reaction to prevent mixing with the resist upper layer film and the resist middle layer film. The baking is preferably performed at a temperature of 100°C or higher and 600°C or lower for 10 to 600 seconds, more preferably at a temperature of 200°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

In the method for forming a resist underlayer film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film.

By baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation of the metal-containing film during the baking, the absorption does not increase and the etching resistance does not decrease, which is preferable.

### <Patterning Process Using Composition for Forming Resist Underlayer Film>

The present invention provides, as a patterning process according to a two-layer resist process using the above-described composition for forming a metal-containing film, a patterning process including:
forming a metal-containing film on a substrate to be processed by using the composition for forming a metal-containing film;
forming a resist upper layer film on the metal-containing film by using a photoresist material;
subjecting the resist upper layer film to pattern exposure and then development with a developer to form a pattern in the resist upper layer film;
transferring the pattern to the metal-containing film by dry etching while using the resist upper layer film having the formed pattern as a mask; and
processing the substrate to be processed while using the metal-containing film having the formed pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed using an etching gas mainly containing a chlorine-based gas.

The present invention provides, as a patterning process according to a three-layer resist process using the above-described composition for forming a metal-containing film, a patterning process including:
forming a metal-containing film on a substrate to be processed by using the composition for forming a metal-containing film;
forming a silicon-containing resist middle layer film on the metal-containing film by using a silicon-containing resist middle layer film material;
forming a resist upper layer film on the resist middle layer film by using a photoresist material;
subjecting the resist upper layer film to pattern exposure and then development with a developer to form a pattern in the resist upper layer film;
transferring the pattern to the resist middle layer film by dry etching while using the resist upper layer film having the formed pattern as a mask;
transferring the pattern to the metal-containing film by dry etching while using the resist middle layer film having the transferred pattern as a mask; and
processing the substrate to be processed while using the metal-containing film having the formed pattern as a mask to form the pattern in the substrate to be processed.

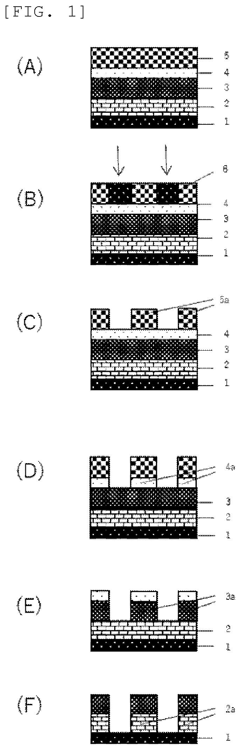

An example of a three-layer resist process specifically described with reference to FIG. 1 is as follows. In the case of a three-layer resist process, as shown in FIG. 1 (A), a metal-containing film (metal-containing resist underlayer film) 3 is formed on a layer 2 to be processed laminated on a substrate 1 to be processed by using the inventive composition for forming a metal-containing film; then, a silicon-containing resist middle layer film 4 is formed; and a resist upper layer film 5 is formed thereon.

Next, as shown in FIG. 1 (B), exposure is conducted for required portion (exposure portion) 6 of the resist upper layer film 5, followed by post-exposure baking (PEB) and development, to form a resist upper layer film pattern 5a (FIG. 1 (C)). The obtained resist upper layer film pattern 5a is then used as a mask to etch the silicon-containing resist middle layer film 4 by using a CF-based gas to form a silicon-containing resist middle layer film pattern 4a (FIG. 1 (D)). After removing the resist upper layer film pattern 5a, chlorine plasma etching of the metal-containing film 3 is performed while using the obtained silicon-containing resist middle layer film pattern 4a as a mask to form a metal-containing film pattern (metal-containing resist underlayer film pattern) 3a (FIG. 1 (E)). Further, after removing the silicon-containing resist middle layer film pattern 4a, the layer 2 to be processed is etched while using the metal-containing film pattern 3a as a mask to form a pattern 2a in the layer to be processed (FIG. 1 (F)).

The silicon-containing resist middle layer film in the three-layer resist process exhibits etching resistance with respect to a chlorine-based gas and a hydrogen-based gas. Therefore, the dry etching of the metal-containing film that is performed while using the silicon-containing resist middle layer film as a mask in the three-layer resist process is preferably performed using an etching gas mainly containing a chlorine-based gas or a hydrogen-based gas.

As the silicon-containing resist middle layer film in the three-layer resist process, a polysiloxane-based middle layer film is also favorably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is crosslinked by an acid or heat.

In addition, the present invention provides a patterning process by way of a four-layer resist process using such a composition for forming a metal-containing film, the patterning process including the steps of:
forming a metal-containing film on a substrate to be processed by using the above-described composition for forming a metal-containing film;
forming a silicon-containing resist middle layer film on the metal-containing film by using a silicon-containing resist middle layer film material;
forming an organic antireflective film (BARC) or an adhesive film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the metal-containing film by dry etching while using the silicon-containing resist middle layer film having the transferred pattern as a mask; and
processing the substrate to be processed while using the metal-containing film having the formed pattern as a mask, thereby forming the pattern in the substrate to be processed.

Alternatively, an inorganic hard mask may be formed instead of the silicon-containing resist middle layer film. In this case, a semiconductor device circuit pattern can be formed on a substrate, at least, by:
forming a metal-containing film on a body to be processed by using the inventive composition for forming a metal-containing film;
forming an inorganic hard mask selected from a silicon oxide film, a silicon nitride film, and a silicon oxynitride film on the metal-containing film;
forming a resist upper layer film on the inorganic hard mask by using a photoresist composition;
forming a circuit pattern in the resist upper layer film;
etching the inorganic hard mask while using the resist upper layer film having the formed pattern as a mask;
etching the metal-containing film while using the inorganic hard mask having the formed pattern as a mask; and
furthermore, etching the body to be processed while using the metal-containing film having the formed pattern as a mask to form the pattern in the body to be processed.

As described above, when the inorganic hard mask is formed on the metal-containing film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask is preferably 5 to 200 nm, more preferably 10 to 100 nm. The SiON film, which has a high function as an antireflective film, is the most preferably used as the inorganic hard mask. Since the substrate temperature increases to 300 to 500°C when the SiON film is formed, the metal-containing film needs to withstand a temperature of 300 to 500°C. The composition for forming a metal-containing film used in the present invention has high heat resistance and can withstand a high temperature of 300 to 500°C. Thus, the metal-containing film formed by spin-coating and the inorganic hard mask formed by the CVD method or the ALD method can be combined.

A photoresist film may be formed on the inorganic hard mask as the resist upper layer film as described above. Alternatively, an organic antireflective film (BARC) or an adhesive film may be formed on the inorganic hard mask by spin-coating, and a photoresist film may be formed thereon. In particular, when a SiON film is used as the inorganic hard mask, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In addition, the present invention provides a patterning process according to a multilayer resist process using such a composition for forming a metal-containing film. In this case, a semiconductor device circuit pattern can be formed on a substrate in the following manner:
forming a resist underlayer film on a substrate to be processed;
applying the inventive composition for forming a metal-containing film onto the resist underlayer film and then heating to form a metal-containing film;
forming a resist upper layer film on the metal-containing film by using a photoresist material;
subjecting the resist upper layer film to pattern exposure and then development with a developer to form a pattern in the resist upper layer film;
transferring the pattern to the metal-containing film by dry etching while using the resist upper layer film having the formed pattern as a mask;
transferring the pattern to the resist underlayer film by dry etching while using the metal-containing film having the transferred pattern as a mask; and
furthermore, processing the substrate to be processed while using the resist underlayer film having the formed pattern as a mask to form the pattern in the substrate to be processed.

A photoresist film may be formed on the metal-containing film as a resist upper layer film as described above. Alternatively, an organic adhesive film may be formed on the metal-containing film by spin-coating, and a photoresist film may be formed thereon.

As described above, when the resist underlayer film is formed on the substrate to be processed, the resist underlayer film can be formed by a method using a coating-type organic underlayer film material, a CVD method, an ALD method, or the like. Examples of the coating-type organic underlayer film material include resins and compositions disclosed in JP2012-001687A, JP2012-077295A, JP2004-264710A, JP2005-043471A, JP2005-250434A, JP2007-293294A, JP2008-065303A, JP2004-205685A, JP2007-171895A, JP2009-014816A, JP2007-199653A, JP2008-274250A, JP2010-122656A, JP2012-214720A, JP2014-029435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-044022A, etc.

The resist upper layer film in the multilayer resist process described above may be either a positive type or a negative type, and it is possible to use a film similar to the typically used photoresist composition. The prebaking, which is conducted after the spin-coating with the photoresist composition, is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 30 to 500 nm, particularly preferably 50 to 400 nm.

Furthermore, examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. The etching of a silicon-containing resist middle layer film or an inorganic hard mask in the three-layer resist process is performed while using the upper layer resist pattern as a mask by using a fluorocarbon-based gas. In this manner, a silicon-containing resist middle layer film pattern or an inorganic hard mask pattern is formed.

Next, the metal-containing film is etched while using the obtained silicon-containing resist middle layer film pattern or inorganic hard mask pattern as a mask. The etching of the metal-containing film is preferably performed using an etching gas mainly containing a chlorine-based gas.

The subsequent etching of the body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The metal-containing film obtained by using the inventive composition for forming a metal-containing film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the patterning process using the inventive composition for forming a metal-containing film, it is preferable to use a substrate to be processed having a structure or step having a height of 30 nm or more. As described above, the inventive composition for forming a metal-containing film has excellent filling and planarizing properties, so that a flat cured film can be formed even when the substrate to be processed has a step (irregularities) or structure having a height of 30 nm or more. The height of the structure or step of the substrate to be processed is preferably 30 nm or more, more preferably 50 nm or more, and more preferably 100 nm or more. In the method of processing a stepped substrate having a pattern of the above-described height, filling and planarizing by forming a film of the inventive composition for forming a metal-containing film makes it possible to achieve a uniform film thickness in the subsequently formed resist middle layer film and resist upper layer film. Therefore, it is easy to ensure the exposure depth margin (DOF) at the time of photolithography, which is very desirable.

### <Tone-Reversal Patterning Process Using Composition for Forming Metal-Containing Film>

The present invention also provides, as a tone-reversal patterning process using such a composition for forming a metal-containing film, a tone-reversal patterning process including the steps of:
forming a resist underlayer film on a substrate to be processed;
forming a resist middle layer film or a combination of an organic thin film and an inorganic hard mask middle layer film selected from a silicon oxide film, a silicon nitride film, and a silicon oxynitride film on the resist underlayer film;
forming a resist upper layer film on the resist middle layer film or the combination of the organic thin film and the inorganic hard mask middle layer film by using a photoresist material;
subjecting the resist upper layer film to pattern exposure and then development with a developer to form a pattern in the resist upper layer film;
transferring the pattern to the resist middle layer film or the organic thin film and the inorganic hard mask middle layer film by dry etching while using the resist upper layer film having the formed pattern as a mask;
transferring the pattern to the resist underlayer film by dry etching while using the resist middle layer film or the inorganic hard mask middle layer film having the transferred pattern as a mask;
covering the resist underlayer film having the formed pattern with a metal-containing film by using the above-described composition for forming a metal-containing film, thereby filling a space between the resist underlayer film patterns with the metal-containing film;
etching back the metal-containing film covering the resist underlayer film having the formed pattern by a chemical stripper or dry etching to expose an upper surface of the resist underlayer film having the formed pattern;
removing the resist middle layer film or the inorganic hard mask middle layer film remaining on the upper surface of the resist underlayer film by dry etching;
removing, by dry etching, the resist underlayer film having the formed pattern with an exposed surface to form a reverse pattern of an original pattern on the metal-containing film; and
processing the substrate to be processed while using the metal-containing film having the formed reverse pattern as a mask to form the reverse pattern in the substrate to be processed.

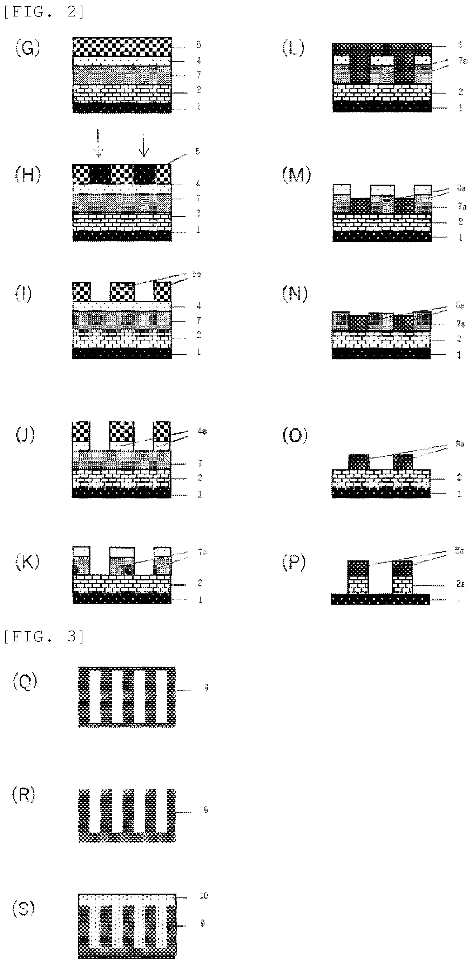

An example of formation of a tone-reversal pattern is specifically explained below by referring to FIG. 2. As shown in FIG. 2 (G), a resist underlayer film 7 formed from a coating-type organic underlayer film composition is formed on a layer 2 to be processed stacked on a substrate 1 to be processed; thereafter, a silicon-containing resist middle layer film 4 is formed, and a resist upper layer film 5 is further formed thereon.

Next, as shown in FIG. 2 (H), exposure is conducted for required portion (exposure portion) 6 of the resist upper layer film 5, followed by PEB and development, to form a resist upper layer film pattern 5a (FIG. 2 (I)). The obtained resist upper layer film pattern 5a is then used as a mask to etch the silicon-containing resist middle layer film 4 by using a CF-based gas to form a silicon-containing resist middle layer film pattern 4a (FIG. 2 (J)). After removing the resist upper layer film pattern 5a, oxygen plasma etching of the resist underlayer film 7 formed from the coating-type organic underlayer film composition is performed while using the obtained silicon-containing resist middle layer film pattern 4a as a mask to form a resist underlayer film pattern 7a formed of the coating-type organic underlayer film composition (FIG. 2 (K)).

After applying the inventive composition for forming a metal-containing film onto the resist underlayer film pattern 7a formed of the coating-type organic underlayer film composition, heating is performed to cover the resist underlayer film pattern with a metal-containing film 8, thereby filling a space between the resist underlayer film patterns 7a formed of the coating-type organic underlayer film composition with the metal-containing film (FIG. 2 (L)). Then, the metal-containing film 8 covering the resist underlayer film pattern 7a formed of the coating-type organic underlayer film composition is etched back by a chemical stripper or dry etching, thereby exposing an upper surface of the resist underlayer film pattern 7a formed of the coating-type organic underlayer film composition (FIG. 2 (M)). Further, the silicon-containing resist middle layer film pattern 4a remaining on the upper surface of the resist underlayer film pattern 7a formed of the coating-type organic underlayer film composition is removed by dry etching (FIG. 2 (N)). Subsequently, the resist underlayer film pattern 7a formed of the coating-type organic underlayer film composition is removed by dry etching to form a reverse pattern of the original pattern in the metal-containing film (form a metal-containing film pattern 8a as a reverse pattern of the resist underlayer film pattern) (FIG. 2 (O)); after this step, the substrate to be processed is processed while using the metal-containing film pattern 8a as a reverse pattern of the resist underlayer film pattern as a mask to form a tone-reversal pattern in the substrate to be processed (FIG. 2 (P)).

As described above, when the resist underlayer film is formed on the substrate to be processed, the resist underlayer film can be formed by a method using a coating-type organic underlayer film material, a CVD method, an ALD method, or the like. Examples of the coating-type organic underlayer film material include resins and compositions disclosed in JP2012-1687A, JP2012-77295A, JP2004-264710A, JP2005-043471A, JP2005-250434A, JP2007-293294A, JP2008-65303A, JP2004-205685A, JP2007-171895A, JP2009-14816A, JP2007-199653A, JP2008-274250A, JP2010-122656A, JP2012-214720A, JP2014-29435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-44022A, etc.

In the tone-reversal patterning process, after the obtained resist underlayer film pattern is coated with the composition for forming a metal-containing film, it is preferable to remove the metal-containing film by using a dry etching gas mainly containing a chlorine-based gas so as to expose the upper surface of the resist underlayer film pattern. Thereafter, the resist middle layer film or the hard mask middle layer film remaining on the resist underlayer film is removed by dry etching using a fluorocarbon-based gas, and the resist underlayer film pattern having an exposed surface is removed by dry etching using an oxygen-based gas to form a metal-containing film pattern.

In the tone-reversal patterning process described above, the resist underlayer film pattern preferably has a step or a structure with a height of 30 nm or more. As described above, the inventive composition for forming a metal-containing film has excellent filling and planarizing properties. Thus, even when the film to be processed has a step (irregularities) or a structure with a height of 30 nm or more, a flat cured film can be formed. The height of the structure or the step of the resist underlayer film pattern is preferably 30 nm or more, more preferably 50 nm or more, and still more preferably 100 nm or more. In the method of reversing the resist underlayer film pattern having a pattern with the above-described height, by performing filling and planarization by forming a film from the inventive composition for forming a metal-containing film, inversion/transfer of the pattern can be performed with a high degree of accuracy, which is very desirable. Reversing the resist underlayer film pattern by using the composition for forming a metal-containing film allows a desired resist pattern to be formed on a film to be processed with a high degree of accuracy due to the excellence in resistance in dry etching using a fluorocarbon-based gas relative to the resist underlayer film using a previously-known coating-type organic underlayer film material.

### EXAMPLES

The present invention is more specifically described below with reference to Synthesis Examples, Comparative Synthesis Examples, Examples, and Comparative Examples. However, the present invention is not limited to these Examples. To obtain molecular weight and dispersity, weight-average molecular weight (Mw) and number-average molecular weight (Mn) on polystyrene basis were measured by gel permeation chromatography (GPC) using tetrahydrofuran as an eluent, and dispersity (Mw/Mn) was calculated from these values.

### [Synthesis Examples]

In the following Synthesis Examples and Comparative Examples, the tin compounds Sn ((Sn-1) to (Sn-5)), starting material group X ((X-1) to (X-12)), and starting material group G ((G-1) to (G-7)) shown below were used. The respective starting material groups are shown below.

### Tin compounds Sn:

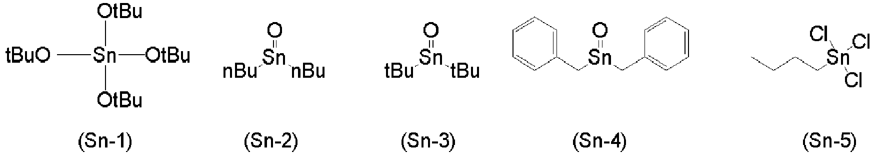

### Starting material group X:

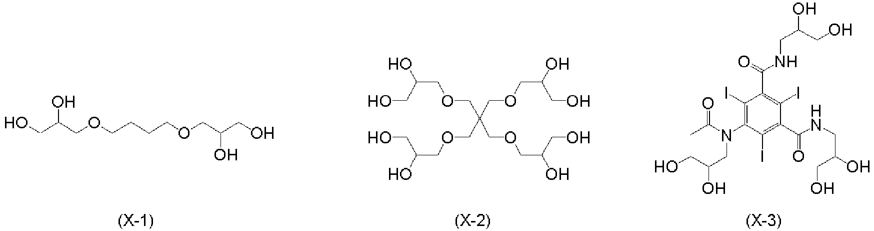

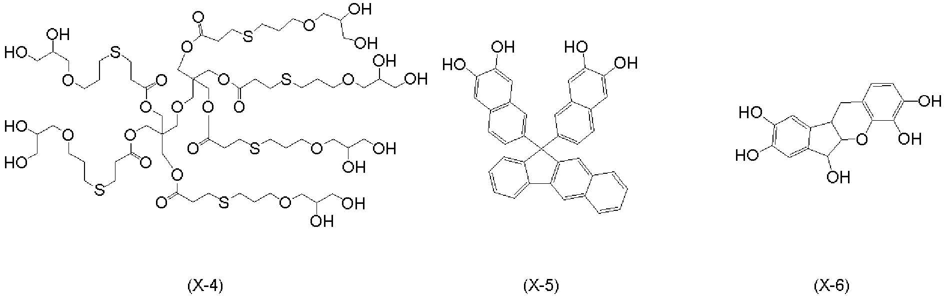

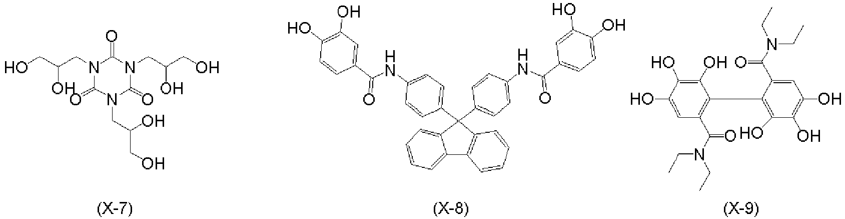

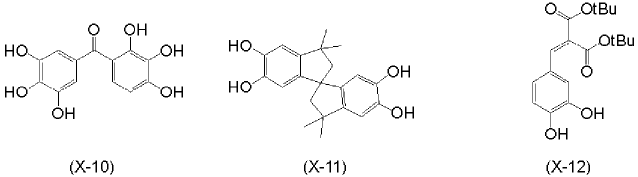

### Starting material group G:

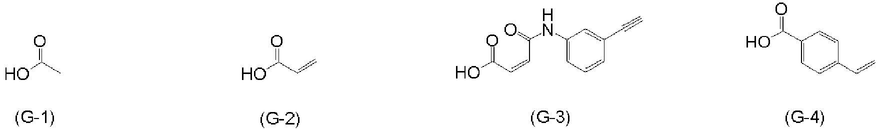

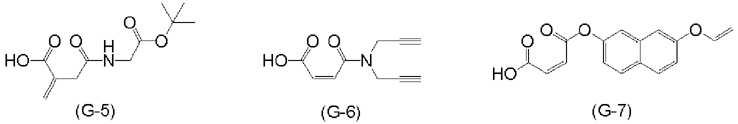

### [Synthesis Example 1] Synthesis of Compound (A-1) for Forming Metal-Containing Film

5.0 g of the tin compound (Sn-4), 1.9 g of the starting material (X-1), and 100 g of toluene were added together, and a reaction was allowed to take place at 130°C for 7 hours while removing water. After the reaction, the solvent was removed under reduced pressure to give a compound (A-1).
(A-1): Mw=554, Mw/Mn=1.04

### [Synthesis Example 2] Synthesis of Compound (A-2) for Forming Metal-Containing Film

5.0 g of the tin compound (Sn-1), 1.6 g of the starting material (X-2), and 100 g of toluene were added together, and a reaction was allowed to take place at 100°C for 7 hours while removing tert-butyl alcohol. After the reaction, the solvent was removed under reduced pressure to give a compound (A-2).
(A-2): Mw=890, Mw/Mn=1.09

### [Synthesis Example 4] Synthesis of Compound (A-4) for Forming Metal-Containing Film

5.0 g of the tin compound (Sn-5), 4.7 g of the starting material (X-4), and 100 g of toluene were added together, and a reaction was allowed to take place at 100°C for 7 hours. After the reaction, the solvent was removed under reduced pressure to give a compound (A-4).
(A-4): Mw=1530, Mw/Mn=1.26

### [Synthesis Examples 3 and 5 to 8] Synthesis of Compounds (A-3) and (A-5) to (A-8) for Forming Metal-Containing Film

(A-3) and (A-5) to (A-8) were obtained under the same reaction conditions as in Synthesis Example 1, except that the tin compound Sn and the starting material group X were used at the charging amounts shown in Tables 1-1 and 1-2. The weight-average molecular weight (Mw) and the dispersity (Mw/Mn) of these compounds were determined. Table 2 shows the results.

### [Synthesis Examples 9 to 14] Synthesis of Compounds (A-9) to (A-14) for Forming Metal-Containing Film

(A-9) to (A-14) were obtained under the same reaction conditions as in Synthesis Example 4, except that the starting material group X and the starting material group G were used at the charging amounts shown in Table 1-2. The weight-average molecular weight (Mw) and the dispersity (Mw/Mn) of these compounds were determined. Table 2 shows the results.

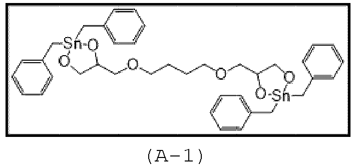

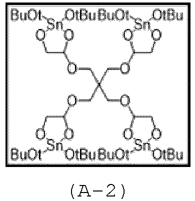

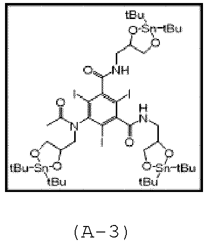

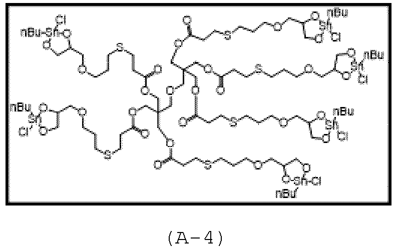

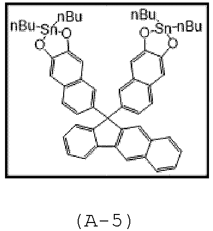

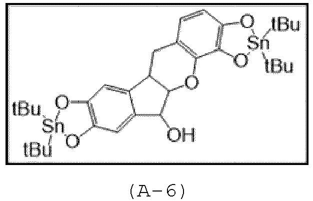

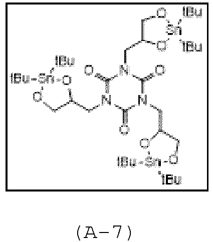

**[Table 1-1]**

| Synthesis Example | Tin compound Sn | Starting material group X | Starting material group G | Compound |
|---|---|---|---|---|
| 1 | (Sn-4) 5.0 g | (X-1) 1.9 g | - | (A-1) |
| 2 | (Sn-1) 5.0 g | (X-2) 1.6 g | - | (A-2) |
| 3 | (Sn-3) 5.0 g | (X-3) 5.4 g | - | (A-3) |
| 4 | (Sn-5) 5.0 g | (X-4) 4.7 g | - | (A-4) |
| 5 | (Sn-2) 5.0 g | (X-5) 5.3 g | - | (A-5) |
| 6 | (Sn-3) 5.0 g | (X-6) 3.0 g | - | (A-6) |
| 7 | (Sn-3) 5.0 g | (X-7) 2.3 g | - | (A-7) |

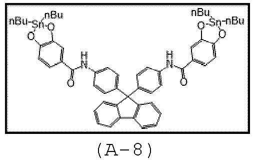

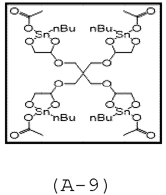

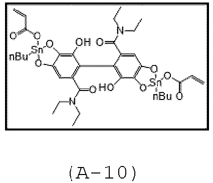

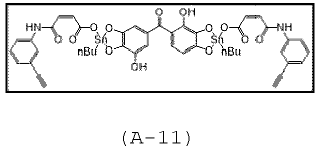

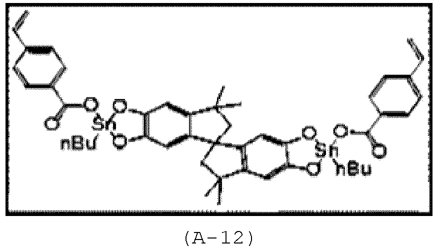

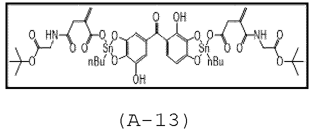

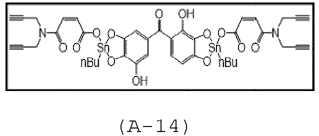

**[Table 1-2]**

| Synthesis Example | Tin compound Sn | Starting material group X | Starting material group G | Compound |
|---|---|---|---|---|
| 8 | (Sn-2) 5.0 g | (X-8) 6.2 g | - | (A-8) |
| 9 | (Sn-5) 5.0 g | (X-2) 1.9 g | (G-1) 4.3g | (A-9) |
| 10 | (Sn-5) 5.0 g | (X-9) 4.0 g | (G-2) 3.1g | (A-10) |
| 11 | (Sn-5) 5.0 g | (X-10) 2.5 g | (G-3) 7.6g | (A-11) |
| 12 | (Sn-5) 5.0 g | (X-11) 3.0 g | (G-4) 5.3g | (A-12) |
| 13 | (Sn-5) 5.0 g | (X-10) 2.5 g | (G-5) 8.6g | (A-13) |
| 14 | (Sn-5) 5.0 g | (X-10) 2.5 g | (G-6) 6.8g | (A-14) |

### [Synthesis of Compound (R-1) for Forming Metal-Containing Film for Comparative Example]

5.0 g of the tin compound (Sn-2), 11.4 g of the starting material group G (G-7), and 100 g of toluene were added together, and a reaction was allowed to take place at 130°C for 7 hours while removing water. After the reaction, the solvent was removed under reduced pressure to give (R-1).

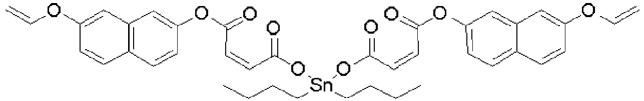

### [Synthesis of Compound (R-2) for Forming Metal-Containing Film for Comparative Example]

5.0 g of the tin compound (Sn-2), 6.8 g of the starting material group X (X-12), and 50 g of toluene were added together, and a reaction was allowed to take place at 130°C for 7 hours while removing water. After the reaction, the solvent was removed under reduced pressure to give (R-2).

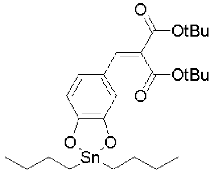

The weight-average molecular weight (Mw) and the dispersity (Mw/Mn) of these compounds were determined. Table 2 shows the results.

**[Table 2]**

| Compound | Mw | Mw/Mn |
|---|---|---|
| A-1 | 554 | 1.04 |
| A-2 | 890 | 1.09 |
| A-3 | 921 | 1.12 |
| A-4 | 1530 | 1.26 |
| A-5 | 602 | 1.11 |
| A-6 | 495 | 1.03 |
| A-7 | 563 | 1.09 |
| A-8 | 598 | 1.08 |
| A-9 | 864 | 1.18 |
| A-10 | 610 | 1.22 |
| A-11 | 638 | 1.34 |
| A-12 | 589 | 1.41 |
| A-13 | 608 | 1.37 |
| A-14 | 614 | 1.45 |
| R-1 | 260 | 1.02 |
| R-2 | 356 | 1.07 |

### [Synthesis of Compound (R-3) for Forming Metal-Containing Film for Comparative Example]

As a metal-containing compound assumed to be used for a photoresist, the tin compound reported in [Synthesis Example 8] of JP7028940B2 was synthesized.

3 g of isopropyltriphenyltin and 1.4 g of succinic acid were dissolved in 20 ml of acetonitrile, and then refluxed for 24 hours. After the reaction, the solvent was removed under reduced pressure to give a tin-containing compound (R-3).

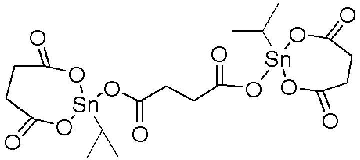

### [Synthesis of Compound (R-4) for Forming Metal-Containing Film for Comparative Example]

10 g of catechol, 6.6 g of formaldehyde, and 30 g of PGME (propylene glycol monomethyl ether) were added together, and homogenized at an internal temperature of 100°C. After that, a mixed solution of 0.2 g of p-toluenesulfonic acid monohydrate and 3.0 g of PGME that had been mixed and homogenized beforehand was slowly added dropwise thereto, and a reaction was allowed to take place at an internal temperature of 120°C for 8 hours. After the reaction was completed, 300 ml of MIBK was added thereto, the product was washed four times with 200 ml of pure water, and the organic layer was evaporated under reduced pressure to dryness. After that, 22 g of the tin starting material (Sn-2) and 300 g of toluene were added thereto, and the mixture was stirred at 130°C for 8 hours. After the reaction, the solvent was removed under reduced pressure to give (R-4).

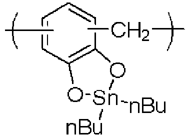

### [Synthesis of Compound (R-5) for Forming Metal-Containing Film for Comparative Example]

As a compound having a different metal from the inventive compound for forming a metal-containing film, a titanium compound reported in [Synthesis Example A-II] of JP6189758B2 was synthesized.

2-propanol (IPA) solution (500 g) of deionized water (27 g) was dropped while stirring into an IPA solution (500 g) of a titanium tetraisopropoxide (manufactured by Tokyo Chemical Industry Co., Ltd.) (284 g) at room temperature for 2 hours. 2-methyl-2,4-pentanediol (120 g) was added to the obtained solution and agitated at room temperature for 30 minutes. After the solution was concentrated under reduced pressure at 30°C, it was heated to 60°C and heating was continued under reduced pressure to generate no distillate. Then, PGMEA (1,200 g) was added thereto and heated under reduced pressure at 40°C until no IPA was distilled to obtain a PGMEA solution of a titanium-containing compound (R-5) (1,000 g) (compound concentration: 20 mass%). The molecular weight of the compound measured in terms of polystyrene was Mw = 1,100.

### [Synthesis of Resin (R-6) for Forming Organic Film for Comparative Example]

Under a nitrogen atmosphere, 160.2 g of 1,5-dihydroxynaphthalene, 56.8 g of formaldehyde, and 300 g of propylene glycol monomethyl ether (PGME) were added together, and homogenized at an internal temperature of 100°C. After that, a mixed solution of 8.0 g of p-toluenesulfonic acid monohydrate and 8.0 g of PGME that had been mixed and homogenized beforehand was added dropwise slowly, and a reaction was allowed to take place at an internal temperature of 80°C for 8 hours. After the reaction was completed, the product was cooled to room temperature, and 2,000 ml of MIBK was added thereto. The product was washed six times with 500 ml of pure water, and the organic layer was evaporated under reduced pressure to dryness. After adding 300 g of THF to the residue to yield a homogeneous solution, a crystal was precipitated in 2,000 g of hexane. The precipitated crystal was separated by filtration, washed twice with 500 g of hexane, and collected. The collected crystal was vacuum-dried at 70°C, thereby obtaining a resin (R-6).

The weight-average molecular weight (Mw) and the dispersity (Mw/Mn) were determined by GPC, and the following results were obtained.
(R-6): Mw=3,300, Mw/Mn=2.54

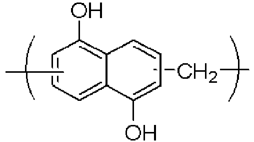

### [Composition UDL-1 for Forming Metal-Containing Film]

The compound (A-1) for forming a metal-containing film was dissolved at a ratio shown in Table 3 in a solvent of propylene glycol monomethyl ether acetate (PGMEA) or cyclohexanone (CyHO) containing 0.5 mass% of a surfactant FC-4430 (manufactured by Sumitomo 3M Limited), and the solution was filtered through a 0.2-µm membrane filter to prepare a composition (UDL-1) for forming a metal-containing film.

### [Preparation of Compositions (UDL-2 to -18) for Forming Metal-Containing Film and Compositions (Comparative UDL-1 to -6) for Forming Metal-Containing Film for Comparative Examples]

Each chemical liquid was prepared in the same manner as UDL-1, except that the type and the contained amount of each component were as shown in Table 3. In Table 3, "-" indicates that the component was not used. The following formula (C-1) was used for the crosslinking agent, 1,6-diacetoxyhexane (boiling point: 260°C) was used as the high-boiling-point solvent (D-1), a polymer (F-1) for a flowability accelerator was used, and the formula (TAG-1), shown later, was used for the thermal acid generator (TAG).

### [Crosslinking Agent]

The crosslinking agent (C-1) used in a composition for forming a metal-containing film is shown below.

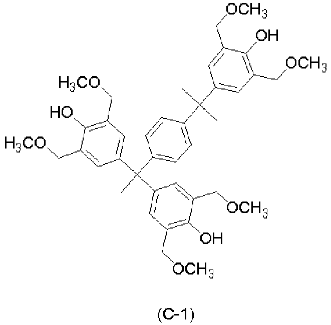

### [Synthesis Example of Polymer for Flowability Accelerator] Synthesis of Polymer (F-1) for Flowability Accelerator

Under a nitrogen atmosphere, 20.0 g of cresol novolak, 27.6 g of potassium carbonate, and 100 g of DMF were added together to form a homogeneous dispersion at an internal temperature of 50°C. 11.9 g of propargyl bromide was slowly added thereto, and a reaction was allowed to take place at an internal temperature of 50°C for 24 hours. To the reaction solution, 300 ml of methyl isobutyl ketone and 300 g of pure water were added to dissolve the precipitated salt, and then the separated aqueous layer was removed. Furthermore, the organic layer was washed six times with 100 g of a 3% aqueous nitric acid solution and 100 g of pure water, and then the organic layer was evaporated under reduced pressure to dryness to obtain a resin (F-1).

The weight-average molecular weight (Mw) and the dispersity (Mw/Mn) were determined by GPC, and the following results were obtained.

### (F-1): Mw=8,500, Mw/Mn=3.46

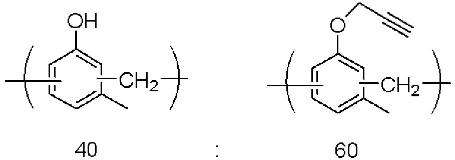

### [Thermal Acid Generator]

The thermal acid generator (TAG-1) used in a composition for forming a metal-containing film is shown below.

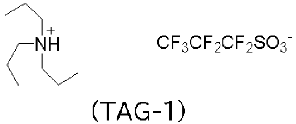

**[Table 3]**

| Composition for forming metal-containing film | Compound for forming metal-containing film (parts by mass) | Additive (parts by mass) | Solvent (parts by mass) |
|---|---|---|---|
| UDL-1 | A-1 (15) | - | CyHO (85) |
| UDL-2 | A-2 (15) | - | CyHO (85) |
| UDL-3 | A-3 (15) | - | CyHO (85) |
| UDL-4 | A-4 (15) | - | CyHO (85) |
| UDL-5 | A-5 (15) | - | CyHO (85) |
| UDL-6 | A-6 (15) | - | CyHO (85) |
| UDL-7 | A-7 (15) | - | CyHO (85) |
| UDL-8 | A-8 (15) | - | PGMEA (85) |
| UDL-9 | A-9 (15) | - | PGMEA (85) |
| UDL-10 | A-10 (15) | - | PGMEA (85) |
| UDL-11 | A-11 (15) | - | PGMEA (85) |
| UDL-12 | A-12 (15) | - | PGMEA (85) |
| UDL-13 | A-13 (15) | - | PGMEA (85) |
| UDL-14 | A-14 (15) | - | PGMEA (85) |
| UDL-15 | A-8 (15) | C-1 (10) | PGMEA (75) |
| UDL-16 | A-8 (15) | D-1 (3) | PGMEA (82) |
| UDL-17 | A-13 (15) | TAG-1 (3) | PGMEA (82) |
| UDL-18 | A-13 (15) | F-1 (3) | PGMEA (82) |
| Comparative UDL-1 | R-1 (15) | - | PGMEA (85) |
| Comparative UDL-2 | R-2 (15) | - | PGMEA/CyHO (50/35) |
| Comparative UDL-3 | R-3 (15) | - | CyHO (85) |
| Comparative UDL-4 | R-4 (15) | - | - |
| Comparative UDL-5 | R-5 (15) | - | PGMEA (85) |
| Comparative UDL-6 | R-6 (10) | - | PGMEA (90) |

As shown in Table 3, it was possible to prepare the solutions of the inventive compositions UDL-1 to -7 for forming a metal-containing film with cyclohexanone, and it was observed that these compositions also had sufficient solubility. Meanwhile, it was possible to prepare UDL-8 and UDL-9 to -14, in which the symmetry of the molecule was greatly broken by also using the starting material group G in the reaction, with PGMEA, and it was observed that these compositions were excellent in solvent solubility. Meanwhile, the comparative compound (R-4), being a polymer-type compound, to which it was possible to introduce multiple tin atoms, was not a monomolecular compound, and did not dissolve at all in PGMEA or CyHO, so that it was not possible to prepare a solution.

### [Heat Resistance Evaluation and Solvent Resistance Evaluation]

Each of the compositions (UDL-1 to -18 and comparative UDL-1 to -3 and -5) for forming a metal-containing film prepared as described above was respectively applied onto a silicon substrate and baked at 100°C for 60 seconds, and then the film thickness (a [nm]) was measured. Subsequently, after baking at the baking temperature shown in Table 4 for 60 seconds, the film thickness (b [nm]) was measured, and the difference between the film thicknesses (film remaining percentage: (b/a) × 100) before and after the additional baking was determined.

Furthermore, a PGMEA solvent was dispensed thereon, left to stand for 30 seconds, spin-dried, and baked at 100°C for 60 seconds to evaporate the PGMEA. The film thickness (c [nm]) was then measured. The difference between the film thicknesses (film remaining percentage: (c/b) × 100) before and after the PGMEA treatment was determined. The following Table 4 shows the results.

**[Table 4]**

| Example | Composition for forming metal-containing film | Baking temperature | Film thickness a | Baking temperature | Film thickness b | (b/a) × 100 | Film thickness c after rinsing | (c/b) × 100 |
|---|---|---|---|---|---|---|---|---|
| | | °C | nm | °C | nm | | nm | % |
| Example 1-1 | UDL-1 | 100°C | 210.2 | 250°C | 136.6 | 65% | 136.1 | 99.6% |
| Example 1-2 | UDL-2 | 100°C | 219.1 | 250°C | 175.3 | 80% | 172.7 | 98.5% |
| Example 1-3 | UDL-3 | 100°C | 224.0 | 250°C | 181.4 | 810 | 179.8 | 99.1% |
| Example 1-4 | UDL-4 | 100°C | 218.9 | 250°C | 192.6 | 880 | 190.1 | 98.7% |
| Example 1-5 | UDL-5 | 100°C | 217.3 | 250°C | 193.4 | 89% | 190.3 | 98.4% |
| Example 1-6 | UDL-6 | 100°C | 211.7 | 250°C | 141.8 | 67% | 139.1 | 98.1% |
| Example 1-7 | UDL-7 | 100°C | 208.2 | 250°C | 147.8 | 710 | 145.8 | 98.6% |
| Example 1-8 | UDL-8 | 100°C | 226.4 | 250°C | 206.0 | 91% | 203.9 | 99.0% |
| Example 1-9 | UDL-9 | 100°C | 223.1 | 250°C | 207.5 | 93% | 205.6 | 99.1% |
| Example 1-10 | UDL-10 | 100°C | 219.1 | 250°C | 195.0 | 890 | 194.8 | 99.9% |
| Example 1-11 | UDL-11 | 100°C | 224.3 | 250°C | 201.9 | 90% | 201.9 | 100. 0% |
| Example 1-12 | UDL-12 | 100°C | 219.8 | 250°C | 200.0 | 91% | 200.0 | 100.0% |
| Example 1-13 | UDL-13 | 100°C | 225.1 | 250°C | 198.1 | 880 | 197.3 | 99.6% |
| Example 1-14 | UDL-14 | 100°C | 224.3 | 250°C | 197.4 | 880 | 197.4 | 100.0% |
| Example 1-15 | UDL-15 | 100°C | 231.5 | 250°C | 215.3 | 93% | 215.3 | 100.0% |
| Example 1-16 | UDL-16 | 100°C | 224.5 | 250°C | 202.1 | 90% | 199.2 | 98.6% |
| Example 1-17 | UDL-17 | 100°C | 226.3 | 200°C | 192.4 | 85% | 192.4 | 100.0% |
| Example 1-18 | UDL-18 | 100°C | 229.6 | 250°C | 204.3 | 89% | 203.9 | 99.8% |
| Example 1-19 | UDL-4 | 100°C | 215.3 | 350°C | 103.3 | 48% | 103.3 | 100.0% |
| Example 1-20 | UDL-8 | 100°C | 219.9 | 350°C | 127.5 | 58% | 127.5 | 100.0% |
| Example 1-21 | UDL-11 | 100°C | 223.2 | 350°C | 113.8 | 51% | 113.8 | 100.0% |
| Comparative Example 1-1 | Comparative UDL-1 | 100°C | 225.8 | 250°C | 97.1 | 43% | 96.7 | 99.6% |
| Comparative Example 1-2 | Comparative UDL-2 | 100°C | 198.9 | 250°C | 121.1 | 610 | 121.1 | 100.0% |
| Comparative Example 1-3 | Comparative UDL-3 | 100°C | 203.3 | 250°C | 69.1 | 34% | 69.0 | 99.8% |
| Comparative Example 1-4 | Comparative UDL-1 | 100°C | 239.1 | 350°C | 19.1 | 8% | 19.1 | 100.0% |
| Comparative Example 1-5 | Comparative UDL-2 | 100°C | 197.3 | 350°C | 69.1 | 35% | 69.1 | 100.0% |
| Comparative Example 1-6 | Comparative UDL-5 | 100°C | 314.35 | 300°C | 81.7 | 260 | 81.75 | 100.0% |

As shown in Table 4, the inventive compositions for forming a metal-containing film (Examples 1-1 to 1-18) had a film remaining percentage ((b/a) × 100) of 65% or more after the additional high-temperature baking at 250°C, and it was shown that the compositions had the high-temperature baking resistance required in resist underlayer films. On the other hand, comparative UDL-1 and comparative UDL-2, in which a similar tin compound was used, had a film remaining percentage ((b/a) × 100) of 43% and 61% respectively after the additional high-temperature baking at 250°C, and the inventive compounds had better heat resistance. In addition, comparing Examples 1-19 to 1-21 and Comparative Examples 1-4 and 1-5, where additional high-temperature baking at 350°C was performed, the film remaining percentage ((b/a) × 100) was 48% or more in Examples 1-19 to 1-21, whereas the percentage was 8% and 35% in Comparative Examples 1-4 and 1-5, and it was observed that the inventive compounds also exhibit excellent heat resistance in baking at 350°C. This can be assumed to be because the molecular weight increased due to the organic ligand being bonded to the tin atom at two points in the inventive compounds like in a chelate, so that it was difficult to cleave the tin and the organic group of the mother nucleus, and due to multiple tin atoms being introduced per molecule, so that sublimation was suppressed. Furthermore, the films subjected to an additional high-temperature baking treatment had a film remaining percentage ((c/b) × 100) of more than 98% after the PGMEA rinsing treatment, and it can be observed that a crosslinking reaction occurred and sufficient solvent resistance was exhibited. Furthermore, UDL-10 to -14, in which the starting material group G which has unsaturated bonds or generates a carboxylic acid through thermal/acid elimination, was used in the reaction, had a film remaining percentage ((c/b) × 100) of more than 99.5% after the PGMEA rinsing treatment, and it can be observed that the crosslinking reaction was further promoted and sufficient solvent resistance was exhibited.

Meanwhile, comparing UDL-15, which contained the crosslinking agent (C-1), with UDL-8, which did not contain a crosslinking agent, the film remaining percentage after the baking was increased from 91% to 93%. This is thought to have resulted from the crosslinking occurring efficiently because of the crosslinking agent and sublimation products being suppressed. Meanwhile, comparing UDL-13 with UDL-17, containing the thermal acid generator (TAG-1), UDL-13 had a film remaining percentage ((c/b) × 100) of 99.6% after the PGMEA rinsing after the baking at 250°C, whereas UDL-17 had a film remaining percentage ((c/b) × 100) of 100% after the PGMEA rinsing after the baking at 200°C, and the curability was increased. This is thought to have resulted from the removal of leaving groups and the crosslinking reaction caused by the removal occurring efficiently due to the thermal acid generator being contained.

Meanwhile, in Comparative Example 1-3, where the tin compound reported in [Synthesis Example 8] of JP7028940B2 was used as a tin compound used for a different purpose from that of the present invention, and in Comparative Example 1-6, where the titanium compound reported in [Synthesis Example A-II] of JP6189758B2 was used as a compound having a different metal from that of the inventive compound for forming a metal-containing film, sufficient solvent resistance was exhibited, but the difference between the film thicknesses before and after the additional high-temperature baking was large, and it was shown that volume shrinkage due to high-temperature baking was greater than in the inventive compounds for forming a metal-containing film. Regarding Comparative Example 1-3, two tin atoms were contained per molecule as in the present invention, but the two tin atoms were bonded via a linear divalent organic group, so that the Sn-O bonds themselves, connecting the two tin atoms, were easily cleaved, and furthermore, cyclic structures were contained in the same manner as the present invention, but the structures were seven-membered rings. It is thought that, for these two reasons, thermal stability was poor, and the amount of sublimation products was large, so that heat resistance was insufficient.

### [Filling Property Evaluation]

Each of the compositions (UDL-1 to -18) for forming a metal-containing film, which had favorable film-formability after the additional baking in the solvent resistance evaluation, and comparative UDL-1 to -3 and -5, which had favorable film-formability or with which film-formation was possible, was respectively applied onto an SiO₂ wafer substrate having a dense line-and-space pattern (line width = 40 nm, line depth = 120 nm, distance between the centers of two adjacent lines = 80 nm), followed by heating at the temperature shown in Table 5 for 60 seconds by using a hot plate to form a metal-containing film having a film thickness of 100 nm. The substrate used was a base substrate 9 (SiO₂ wafer substrate) having a dense line-and-space pattern shown in FIG. 3 (Q) (downward view) and (R) (cross-sectional view). The cross-sectional shape of each of the obtained wafer substrates was observed using an electron microscope (S-4700: manufactured by Hitachi, Ltd.), and it was confirmed whether or not it was possible to fill a stepped substrate. Table 5 shows the results. In this evaluation, when a composition for forming a metal-containing film having a poor filling property is used, it is not possible to fill a stepped substrate well. In this evaluation, when a composition for forming a metal-containing film having a desirable filling property is used, as shown in FIG. 3 (S), the space between the lines of the base substrate 9 having the dense line-and-space pattern can be filled with the metal-containing resist underlayer film 10 without voids. "Good" means filling was possible without large voids, "Fair" means voids were visibly present, and "Poor" means filling was not possible.

**[Table 5]**

| Example | Composition for forming metal-containing film | Baking temperature °C | Filling property |
|---|---|---|---|
| Example 2-1 | UDL-1 | 250°C | Good |
| Example 2-2 | UDL-2 | 250°C | Good |
| Example 2-3 | UDL-3 | 250°C | Good |
| Example 2-4 | UDL-5 | 250°C | Good |
| Example 2-5 | UDL-6 | 250°C | Good |
| Example 2-6 | UDL-7 | 250°C | Good |
| Example 2-7 | UDL-9 | 250°C | Good |
| Example 2-8 | UDL-10 | 250°C | Good |
| Example 2-9 | UDL-12 | 250°C | Good |
| Example 2-10 | UDL-13 | 250°C | Good |
| Example 2-11 | UDL-14 | 250°C | Good |
| Example 2-12 | UDL-15 | 250°C | Good |
| Example 2-13 | UDL-16 | 250°C | Good |
| Example 2-14 | UDL-17 | 250°C | Good |
| Example 2-15 | UDL-18 | 250°C | Good |
| Example 2-16 | UDL-4 | 350°C | Good |
| Example 2-17 | UDL-8 | 350°C | Good |
| Example 2-18 | UDL-11 | 350°C | Good |
| Comparative Example 2-1 | Comparative UDL-1 | 250°C | Good |
| Comparative Example 2-2 | Comparative UDL-2 | 250°C | Good |
| Comparative Example 2-3 | Comparative UDL-3 | 250°C | Fair |
| Comparative Example 2-4 | Comparative UDL-1 | 350°C | Poor |
| Comparative Example 2-5 | Comparative UDL-2 | 350°C | Fair |
| Comparative Example 2-6 | Comparative UDL-5 | 300°C | Fair |

It was successfully confirmed that, as shown in Table 5, in Examples 2-1 to 2-15, using the compositions of the present invention for forming a resist metal-containing film, and in Comparative Examples 2-1 to 2-3, using similar tin compounds, it was possible to fill the dense line-and-space pattern without the generation of voids when the baking at 250°C was performed, and excellent filling property was provided. Meanwhile, comparing Examples 2-16 to 2-18 with Comparative Examples 2-4 and 2-5, where baking was performed at 350°C, no voids were generated in Examples 2-16 to 2-18, where the inventive compounds were used, and it was possible to fill the dense line-and-space pattern, whereas in Comparative Examples 2-4 and 2-5, filling was not possible or voids were generated. Meanwhile, voids were also observed at the bottom of the pattern in Comparative Example 2-3, using the tin compound reported in [Synthesis Example 8] of JP7028940B2 as a tin compound having a different purpose from that of the present invention, and in Comparative Example 2-6, using the titanium compound reported in [Synthesis Example A-II] of JP6189758B2. From the above, it can be conjectured that, regarding the inventive compounds, volume shrinkage due to high-temperature baking was small as observed in the above-described solvent resistance evaluation, and therefore, no voids were generated and filling was possible, whereas, regarding the comparative compounds, which underwent great volume shrinkage, voids were generated or filling was not possible because volume shrinkage was great.

### [Planarizing Property Evaluation]

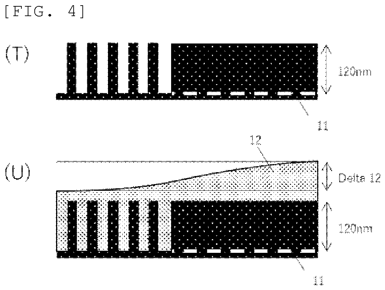

Regarding base substrates 11 (SiO₂ wafer substrates) each having a dense line-and-space pattern shown in FIG. 4 (T), the cross sectional shape of each of the wafer substrates obtained in the filling property evaluation as shown in FIG. 4 (U) was observed using a scanning electron microscope (SEM), and the step (Delta 12 in FIG. 4 (U)) between the line-pattern-dense portion and the non-line-pattern portion of the filling film (metal-containing resist underlayer film 12) was observed using an electron microscope (S-4700: manufactured by Hitachi, Ltd.). Table 6 shows the results. In the present evaluation, it can be said that the smaller the step, the better the planarizing property.

**[Table 6]**

| Example | Composition for forming metal-containing film | Baking temperature °C | Flatness nm |
|---|---|---|---|
| Example 3-1 | UDL-1 | 250°C | 30 |
| Example 3-2 | UDL-2 | 250°C | 29 |
| Example 3-3 | UDL-3 | 250°C | 31 |
| Example 3-4 | UDL-5 | 250°C | 32 |
| Example 3-5 | UDL-6 | 250°C | 33 |
| Example 3-6 | UDL-7 | 250°C | 31 |
| Example 3-7 | UDL-9 | 250°C | 27 |
| Example 3-8 | UDL-10 | 250°C | 29 |
| Example 3-9 | UDL-12 | 250°C | 28 |
| Example 3-10 | UDL-13 | 250°C | 27 |
| Example 3-11 | UDL-14 | 250°C | 28 |
| Example 3-12 | UDL-15 | 250°C | 31 |
| Example 3-13 | UDL-16 | 250°C | 29 |
| Example 3-14 | UDL-17 | 250°C | 26 |
| Example 3-15 | UDL-18 | 250°C | 27 |
| Example 3-16 | UDL-4 | 350°C | 30 |
| Example 3-17 | UDL-8 | 350°C | 33 |
| Example 3-18 | UDL-11 | 350°C | 32 |
| Comparative Example 3-1 | Comparative UDL-1 | 250°C | 29 |
| Comparative Example 3-2 | Comparative UDL-2 | 250°C | 30 |
| Comparative Example 3-3 | Comparative UDL-5 | 300°C | 57 |
| Comparative Example 3-4 | Comparative UDL-6 | 350°C | 49 |

As shown in Table 6, it was observed that better flatness was exhibited in Examples 3-1 to 3-18, where the compositions (UDL-1 to -18) of the present invention for forming a resist metal-containing film were used, than in Comparative Example 3-3, where the titanium compound reported in [Synthesis Example A-II] of JP6189758B2 was used, and Comparative Example 3-4, using an organic resist underlayer film. This is thought to be because the inventive compounds had a long chain alkyl or had an asymmetrical structure, and therefore, were excellent in thermal flowability. It was also observed that equal flatness was exhibited even when baking at 350°C was performed as in Examples 3-16 to 3-18.

Furthermore, in Examples 3-13 and 3-15, where a high-boiling-point solvent (D-1) and a flowability accelerator (F-1) were respectively contained, better planarizing property was exhibited compared to Example 3-15 and Example 3-17, where the additives were not contained. It can be seen that by using a high-boiling-point solvent (D-1) or a flowability accelerator (F-1), the thermal flowability of the compound for forming a metal-containing film can be further enhanced.

### [Etching Resistance Evaluation]

Each of the compositions (UDL-2, UDL-4, UDL-8, and UDL-11) for forming a metal-containing film, comparative UDL-1 and UDL-2, and comparative UDL-5 and -6, which had good film-formability after the additional baking in the solvent resistance evaluation, was respectively applied onto a silicon substrate and heated by using a hot plate at the temperature shown in Table 7 for 60 seconds to form a metal-containing film having a film thickness of 200 nm, etching tests were conducted with a CF-based gas and an O₂-based gas under the following conditions, and the difference in the film thicknesses of the organic film before and after the etching was determined. Table 7 shows the results. For the etching, a dry etching apparatus TE-8500, manufactured by Tokyo Electron Ltd., was used.

Conditions of etching with a CF₄-based gas were as follows.

| | |
|---|---|
| Chamber pressure: | 200 mT |
| RF power: | 300 W |
| CF₄ gas flow rate: | 100 sccm |
| Time: | 20 sec |

Conditions of etching with an O₂-based gas were as follows.

| | |
|---|---|
| Chamber pressure: | 500 mT |
| RF power: | 100 W |
| O₂ gas flow rate: | 30 sccm |
| N₂ gas flow rate: | 270 sccm |
| Time: | 20 sec |

**[Table 7]**

| Example | Composition for forming metal-containing film | Baking temperature °C | Difference in film thickness | |
|---|---|---|---|---|
| | | | CF₄ gas | O₂-based gas |
| Example 4-1 | UDL-2 | 250°C | 14 nm | 4 nm |
| Example 4-2 | UDL-4 | 250°C | 22 nm | 7 nm |
| Example 4-3 | UDL-8 | 250°C | 20 nm | 7 nm |
| Example 4-4 | UDL-11 | 250°C | 20 nm | 6 nm |
| Comparative Example 4-1 | Comparative UDL-1 | 250°C | 25 nm | 7 nm |
| Comparative Example 4-2 | Comparative UDL-2 | 250°C | 18 nm | 4 nm |
| Comparative Example 4-3 | Comparative UDL-5 | 300°C | 18 nm | 7 nm |
| Comparative Example 4-4 | Comparative UDL-6 | 350°C | 35 nm | 39 nm |

As shown in Table 7, it was shown that better etching resistance to the CF-based gas was exhibited and O₂ etching resistance was even better in Examples 4-1 to 4-4, where the compositions of the present invention for forming a resist metal-containing film were used, Comparative Examples 4-1 and 4-2, where a similar composition for forming a metal-containing film was used, and Comparative Example 4-3, where a titanium compound reported in [Synthesis Example A-II] of JP6189758B2 was use, than in Comparative Example 4-4, where an organic resist underlayer film material was used. In particular, Example 4-1 showed excellent etching resistance, and this is thought to be caused by the fact that the tin content was high.

### [Patterning Process (Examples 5-1 to 5-4 and Comparative Examples 5-1 and 5-2)]

Each of the compositions (UDL-2, UDL-4, UDL-8, and UDL-11) for forming a metal-containing film and comparative UDL-5 and -6, which had favorable film-formability after the additional baking in the solvent resistance evaluation, was respectively applied onto an SiO₂ wafer substrate having a trench pattern (trench width: 10 um, trench depth: 0.10 µm), and baked at 250°C for 60 seconds in the atmosphere to form a metal-containing film having a thickness of 100 nm. A silicon-containing resist middle layer film material (SOG-1) was applied thereto, followed by baking at 220°C for 60 seconds to form a resist middle layer film having a thickness of 30 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

The silicon-containing resist middle layer film material (SOG-1) was prepared by dissolving a polymer represented by an ArF silicon-containing middle layer film polymer (SiP1) and a crosslinking catalyst (CAT1) in an organic solvent containing 0.1 mass% of FC-4430 (manufactured by Sumitomo 3M Limited) in the proportion shown in Table 8; and filtering the solution through a filter made of a fluororesin and having a pore size of 0.1 µm.

**[Table 8]**

| | Polymer (parts by mass) | Thermal crosslinking catalyst (parts by mass) | Organic solvent (parts by mass) |
|---|---|---|---|
| SOG-1 | SiP1 (100) | CAT1 (1) | PGEE (4000) |

The structural formulae of the ArF silicon-containing middle layer film polymer (SiP1) and the crosslinking catalyst (CAT1) used are shown below.

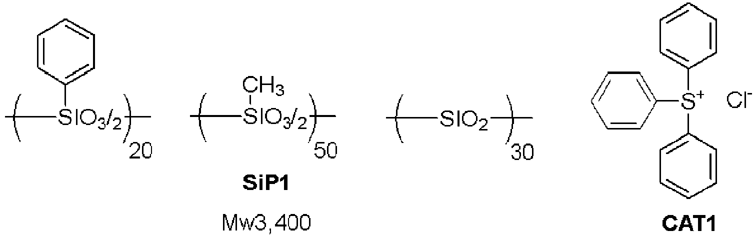

The resist upper layer film material (monolayer resist for ArF) was prepared by dissolving a polymer (RP1), an acid generator (PAG1), and a basic compound (Amine1), each in the proportion shown in Table 9, in a solvent containing 0.1% by mass of a surfactant FC-4430 (manufactured by Sumitomo 3M Limited), and filtering the solution through a 0.1-pm filter made of a fluororesin.

**[Table 9]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2500) |

The polymer (RP1), the acid generator (PAG1), and the basic compound (Amine1) used for the resist upper layer film material (monolayer resist for ArF) are shown below.

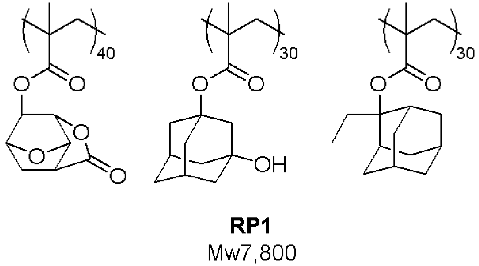

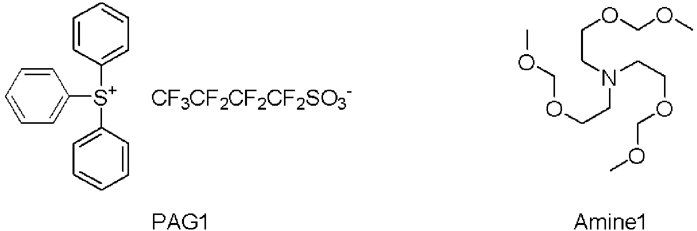

The liquid immersion top coat composition (TC-1) was prepared by dissolving a top coat polymer (PP1) in an organic solvent at the proportion shown in Table 10, and filtering the solution through a 0.1-pm filter made of a fluororesin.

**[Table 10]**

| | Polymer (parts by mass) | Organic solvent (parts by mass) |
|---|---|---|
| TC-1 | PP1 (100) | Diisoamyl ether (2700) 2-methyl-1-butanol (270) |

The polymer (PP1) used for the liquid immersion top coat composition (TC-1) is shown below.

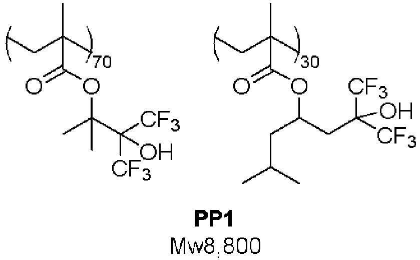

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1 : 1 positive line-and-space pattern (a resist pattern).

Subsequently, the silicon-containing resist middle layer film material (SOG-1) was etched by dry etching while using the resist pattern as a mask to form a hard mask pattern. The metal oxide film was then etched while using the obtained hard mask pattern as a mask to form a metal oxide film pattern, and the SiO₂ film was etched while using the obtained metal oxide film pattern as a mask. As the etching apparatus, ULVAC CE-3001 was used, and the etching conditions were as follows.

Conditions in transferring resist pattern to silicon-containing resist middle layer film material (SOG-1) Conditions of dry etching with CF₄ gas
Pressure: 1 Pa
Antenna RF power: 100 W
Bias RF power: 15 W
CF₄ gas flow rate: 15 sccm
Time: 60 sec

Conditions in transferring SOG-1 hard mask pattern to metal-containing film
Pressure: 1 Pa
Antenna RF power: 320 W
Bias RF power: 30 W
Cl₂ gas flow rate: 25 sccm
Time (Example 5-1 to Example 5-4): 15 sec
Time (Comparative Example 5-1 and Comparative Example 5-2): 60 sec

Conditions in transferring metal-containing film pattern to SiO₂ film
Conditions of dry etching with CF₄ gas
Pressure: 1 Pa
Antenna RF power: 100 W
Bias RF power: 15 W
CF₄ gas flow rate: 15 sccm
Time: 60 sec

Table 11 shows the results obtained by observation of the pattern cross section with an electron microscope (S-4700) manufactured by Hitachi, Ltd.

**[Table 11]**

| Example | Composition for forming metal-containing film | Pattern profile after etching for transferring to substrate |
|---|---|---|
| Example 5-1 | UDL-2 | Vertical profile |
| Example 5-2 | UDL-4 | Vertical profile |
| Example 5-3 | UDL-8 | Vertical profile |
| Example 5-4 | UDL-11 | Vertical profile |
| Comparative Example 5-1 | Comparative UDL-5 | Pattern collapse |
| Comparative Example 5-2 | Comparative UDL-6 | Distorted pattern |

As shown in Table 11, in Examples 5-1 to 5-4, where the compositions of the present invention for forming a metal oxide film were used, the resist upper layer film pattern was successfully transferred to the substrate in the end in every case. Thus, it was confirmed that the composition of the present invention for forming a metal oxide film can be used suitably for fine processing using a multilayer resist method. On the other hand, in Comparative Example 5-1, where the performance in the filling property evaluation and the planarizing property evaluation was found to be insufficient, pattern collapse occurred during patterning, and it was not possible to obtain a favorable pattern in the end. Meanwhile, in Comparative Example 5-2, where there were no problems in the filling property and planarizing property evaluations but insufficient performance was observed in the dry etching resistance evaluation, distortion of the pattern profile occurred at the time of pattern processing, and it was not possible to obtain a favorable pattern in the end.

From the above, the compound of the present invention for forming a metal oxide film is an organotin compound having both high thermal flowability and high thermosetting property, so that a composition for forming a metal-containing film containing the compound can provide a composition for forming a metal-containing film having better dry etching resistance than conventional organic underlayer film materials and also having high filling and planarizing properties. Therefore, such a composition is extremely useful as a resist underlayer film material used in a multilayer resist method and an inverting agent used in a tone-reversal etching method.

The present description includes the following embodiments.
[1]: A compound for forming a metal-containing film, being a reaction product between a compound having two or more diol structures per molecule and a Sn compound, and being a monomolecular compound containing two or more Sn atoms per molecule.
[2]: The compound for forming a metal-containing film of [1], wherein the compound for forming a metal-containing film is represented by the following general formula (M-1) or (M-2), 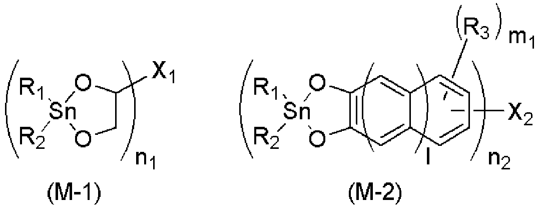 wherein R₁ and R₂ each independently represent a monovalent organic group or a halogen atom; X₁ represents an organic group having a valency of "n₁" selected from the group consisting of a substituted or unsubstituted linear alkyl group having 1 to 20 carbon atoms, a substituted or unsubstituted, branched or cyclic alkyl group having 3 to 70 carbon atoms, a substituted or unsubstituted aliphatic unsaturated hydrocarbon group having 2 to 20 carbon atoms and having one or more double bonds or triple bonds, optionally the alkyl groups and the aliphatic unsaturated hydrocarbon group having an ether group, a thioether group, an ester group, or an amide group, a substituted or unsubstituted aryl group having 6 to 30 carbon atoms, a substituted or unsubstituted arylalkyl group having 6 to 30 carbon atoms, a substituted or unsubstituted triazine ring, a substituted or unsubstituted isocyanuric group, and a substituted or unsubstituted glycoluril group; "n₁" represents an integer of 2 to 6; R₃ represents a substituent other than a hydrogen atom and each independently represents a substituted or unsubstituted alkyl group having 1 to 20 carbon atoms, a substituted or unsubstituted, branched or cyclic alkyl group having 3 to 20 carbon atoms, a substituted or unsubstituted aliphatic unsaturated hydrocarbon group having 2 to 20 carbon atoms and having one or more double bonds or triple bonds, a substituted or unsubstituted alkoxy group having 1 to 20 carbon atoms, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen atom; "l" represents an integer of 0 or 1; "m₁" represents an integer of 0 to 5; X₂ represents a single bond or a linking moiety, the linking moiety being a carbonyl group, an ether group, an ester group, an amide group, an organic group having a valency of "n₂" selected from the group consisting of a substituted or unsubstituted linear alkyl group having 1 to 20 carbon atoms, a substituted or unsubstituted, branched or cyclic alkyl group having 3 to 20 carbon atoms, a substituted or unsubstituted aliphatic unsaturated hydrocarbon group having 2 to 20 carbon atoms and having one or more double bonds or triple bonds, optionally the alkyl group and the aliphatic unsaturated hydrocarbon group having a ketone group, an ether group, an ester group, an amide group, an imine group, a lactone ring, or a sultone ring, a substituted or unsubstituted aryl group having 6 to 36 carbon atoms, a substituted or unsubstituted arylalkyl group having 6 to 36 carbon atoms, and a substituted or unsubstituted triazine ring, or an organic group having a valency of 2×n₂ selected from the group consisting of substituted or unsubstituted, saturated or unsaturated hydrocarbon groups having 2 to 20 carbon atoms and forming a cyclic structure together with the aromatic ring, optionally the hydrocarbon groups having an ether group; and "n₂" represents an integer of 2 to 4.
[3]: The compound for forming a metal-containing film of [2], wherein the R₁ in the general formulae (M-1) and (M-2) is a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, or a substituted or unsubstituted arylalkyl group having 7 to 31 carbon atoms.
[4]: The compound for forming a metal-containing film of [2] or [3], wherein the R₂ represents -OC(=O)R₂', R₂' representing a monovalent organic group.
[5]: The compound for forming a metal-containing film of [4], wherein the R₂' represents one of the following general formulae (A-1) to (A-4), the following general formula (2), or the following general formula (3), 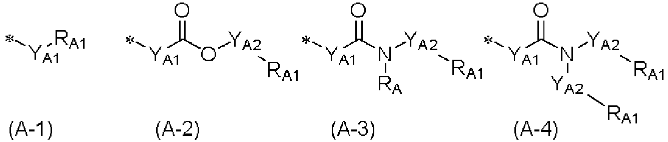 wherein Y_{A1} and Y_{A2} are each identical to or different from each other and represent a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R_{A} represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R_{A1} represents an organic group whose protecting group is to be removed by an action of an acid, heat, or both to generate one or more hydroxy groups or carboxyl groups, R_{A1} being represented by one of the following general formulae (1); and "*" represents an attachment point to the carbonyl group, 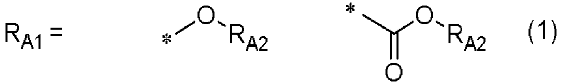 wherein R_{A2} represents an organic group whose protecting group is to be removed by an action of an acid, heat, or both; and "*" represents an attachment point to Y_{A1} or Y_{A2}, 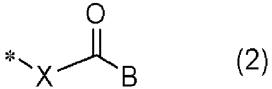 wherein X represents a divalent organic group having 1 to 31 carbon atoms; B represents the following general formula (B); and "*" represents an attachment point to the carbonyl group, 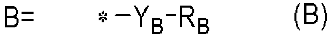 wherein Y_{B} represents a substituted or unsubstituted saturated divalent aliphatic hydrocarbon group having 1 to 20 carbon atoms, a substituted or unsubstituted unsaturated divalent aliphatic hydrocarbon group having 2 to 20 carbon atoms, a substituted or unsubstituted divalent aryl group having 6 to 30 carbon atoms, or a substituted or unsubstituted divalent arylalkyl group having 7 to 31 carbon atoms, optionally Y_{B} being bonded to an adjacent group via an oxygen atom or an NH group; R_{B} represents a hydroxy group or a structure represented by one of the following general formulae (B-1) to (B-3); and "*" represents an attachment point to the carbonyl group, 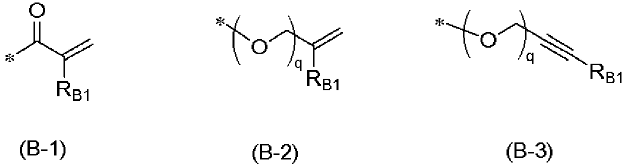 wherein R_{B1} represents a hydrogen atom or a monovalent organic group having 1 to 10 carbon atoms; "q" represents 0 or 1; and "*" represents an attachment point to Y_{B}, 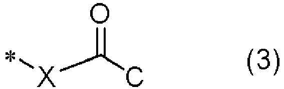 wherein X represents a divalent organic group having 1 to 31 carbon atoms; C represents one of the following general formulae (C-1) to (C-4); and "*" represents an attachment point to the carbonyl group, 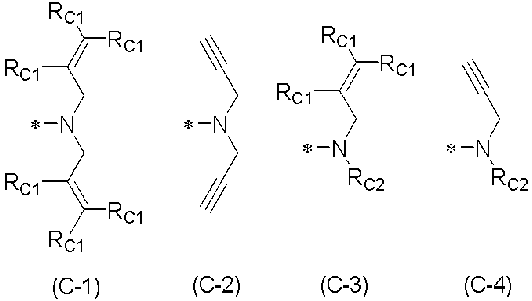 wherein R_{C1}s each independently represent a hydrogen atom or a methyl group and are identical to or different from each other in a single formula; R_{C2} represents a hydrogen atom, a substituted or unsubstituted, saturated or unsaturated monovalent aliphatic hydrocarbon group having 1 to 20 carbon atoms, a substituted or unsubstituted aryl group having 6 to 30 carbon atoms, a substituted or unsubstituted arylalkyl group having 7 to 31 carbon atoms; and "*" represents an attachment point to the carbonyl group.
[6]: The compound for forming a metal-containing film of [5], wherein the Y_{A1} in the general formulae (A-1) to (A-4), the X in the general formula (2), or the X in the general formula (3) is a substituted or unsubstituted unsaturated divalent hydrocarbon group having 2 to 20 carbon atoms.
[7]: The compound for forming a metal-containing film of [5] or [6], wherein the Y_{A1} in the general formulae (A-1) to (A-4), the X in the general formula (2), or the X in the general formula (3) represents one of the following general formulae (4), 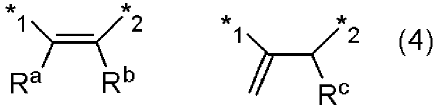 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, substitution positions of "*1" and "*2" optionally being reversed.
[8]: The compound for forming a metal-containing film of any one of [2] to [7], wherein the "m₁" in the general formula (M-2) is 0 or 1, the R₃ being a hydroxy group when m₁=1.
[9]: The compound for forming a metal-containing film of any one of [1] to [8], wherein the compound for forming a metal-containing film satisfies 1.00 ≤ Mw/Mn ≤ 1.50, where Mw is a weight-average molecular weight and Mn is a number-average molecular weight measured by gel permeation chromatography in terms of polystyrene.
[10]: A composition for forming a metal-containing film, the composition functioning as a resist underlayer film material used in manufacturing a semiconductor, the composition comprising: (a) the compound for forming a metal-containing film of any one of [1] to [9]; and (b) an organic solvent.
[11]: The composition for forming a metal-containing film of [10], wherein the composition is usable as a resist underlayer film used in a multilayer resist method, the composition further comprising one or more of (c) a crosslinking agent, (d) a surfactant, (e) a flowability accelerator, and (f) an acid generator.
[12]: The composition for forming a metal-containing film of [10] or [11], wherein the organic solvent (b) is a mixture of one or more kinds of organic solvent having a boiling point of lower than 180°C and one or more kinds of organic solvent having a boiling point of 180°C or higher.
[13]: A patterning process for forming a pattern in a substrate to be processed, comprising the steps of:
   (I-1) applying the composition for forming a metal-containing film of any one of [10] to [12] onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the formed pattern as a mask to form the pattern in the substrate to be processed.
[14]: A patterning process for forming a pattern in a substrate to be processed, comprising the steps of:
   (II-1) applying the composition for forming a metal-containing film of any one of [10] to [12] onto a substrate to be processed, followed by heating to form a metal-containing film;
   (II-2) forming a resist middle layer film on the metal-containing film;
   (II-3) forming a resist upper layer film on the resist middle layer film by using a photoresist material;
   (II-4) subjecting the resist upper layer film to pattern exposure and then development with a developer to form a pattern in the resist upper layer film;
   (II-5) transferring the pattern to the resist middle layer film by dry etching while using the resist upper layer film having the formed pattern as a mask;
   (II-6) transferring the pattern to the metal-containing film by dry etching while using the resist middle layer film having the transferred pattern as a mask; and
   (II-7) processing the substrate to be processed while using the metal-containing film having the formed pattern as a mask to form the pattern in the substrate to be processed.
[15]: A patterning process for forming a pattern in a substrate to be processed, comprising the steps of:
   (III-1) applying the composition for forming a metal-containing film of any one of [10] to [12] onto a substrate to be processed, followed by heating to form a metal-containing film;
   (III-2) forming an inorganic hard mask middle layer film selected from a silicon oxide film, a silicon nitride film, and a silicon oxynitride film on the metal-containing film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film;
   (III-6) transferring the pattern to the organic thin film and the inorganic hard mask middle layer film by dry etching while using the resist upper layer film having the formed pattern as a mask;
   (III-7) transferring the pattern to the metal-containing film by dry etching while using the inorganic hard mask middle layer film having the transferred pattern as a mask; and
   (III-8) processing the substrate to be processed while using the metal-containing film having the formed pattern as a mask to form the pattern in the substrate to be processed.
[16]: A patterning process for forming a pattern in a substrate to be processed, comprising the steps of:
   (IV-1) forming a resist underlayer film on a substrate to be processed;
   (IV-2) applying the composition for forming a metal-containing film of any one of [10] to [12] onto the resist underlayer film, followed by heating to form a metal-containing film;
   (IV-3) forming a resist upper layer film on the metal-containing film by using a photoresist material or forming an organic adhesive film on the metal-containing film by spin-coating and forming a resist upper layer film on the organic adhesive film by using a photoresist material;
   (IV-4) subjecting the resist upper layer film to pattern exposure and then development with a developer to form a pattern in the resist upper layer film;
   (IV-5) transferring the pattern to the metal-containing film or the organic adhesive film and the metal-containing film by dry etching while using the resist upper layer film having the formed pattern as a mask;
   (IV-6) transferring the pattern to the resist underlayer film by dry etching while using the metal-containing film having the transferred pattern as a mask; and
   (IV-7) processing the substrate to be processed while using the resist underlayer film having the formed pattern as a mask to form the pattern in the substrate to be processed.
[17]: A patterning process for forming a pattern in a substrate to be processed, comprising the steps of:
   (V-1) forming a resist underlayer film on a substrate to be processed;
   (V-2) forming a resist middle layer film or a combination of an organic thin film and an inorganic hard mask middle layer film selected from a silicon oxide film, a silicon nitride film, and a silicon oxynitride film on the resist underlayer film;
   (V-3) forming a resist upper layer film on the resist middle layer film or the combination of the organic thin film and the inorganic hard mask middle layer film by using a photoresist material;
   (V-4) subjecting the resist upper layer film to pattern exposure and then development with a developer to form a pattern in the resist upper layer film;
   (V-5) transferring the pattern to the resist middle layer film or the organic thin film and the inorganic hard mask middle layer film by dry etching while using the resist upper layer film having the formed pattern as a mask;
   (V-6) transferring the pattern to the resist underlayer film by dry etching while using the resist middle layer film or the inorganic hard mask middle layer film having the transferred pattern as a mask;
   (V-7) applying the composition for forming a metal-containing film of any one of [10] to [12] onto the resist underlayer film having the formed pattern, followed by heating to cover the resist underlayer film with a metal-containing film, thereby filling a space between the resist underlayer film patterns with the metal-containing film;
   (V-8) etching back the metal-containing film covering the resist underlayer film having the formed pattern by a chemical stripper or dry etching to expose an upper surface of the resist underlayer film having the formed pattern;
   (V-9) removing the resist middle layer film or the inorganic hard mask middle layer film remaining on the upper surface of the resist underlayer film by dry etching;
   (V-10) removing, by dry etching, the resist underlayer film having the formed pattern with an exposed surface to form a reverse pattern of an original pattern on the metal-containing film; and
   (V-11) processing the substrate to be processed while using the metal-containing film having the formed reverse pattern as a mask to form the reverse pattern in the substrate to be processed.
[18]: The patterning process of [15] or [17], wherein the inorganic hard mask middle layer film is formed by a CVD method or an ALD method.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A compound for forming a metal-containing film, being a reaction product between a compound having two or more diol structures per molecule and a Sn compound, and being a monomolecular compound containing two or more Sn atoms per molecule.

2. The compound for forming a metal-containing film according to claim 1, wherein the compound for forming a metal-containing film is represented by the following general formula (M-1) or (M-2), 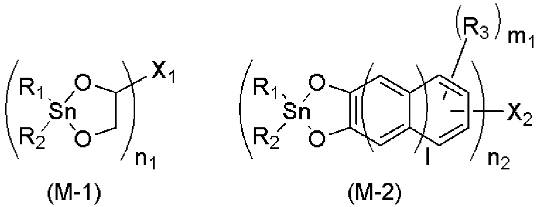 wherein R₁ and R₂ each independently represent a monovalent organic group or a halogen atom; X₁ represents an organic group having a valency of "n₁" selected from the group consisting of a substituted or unsubstituted linear alkyl group having 1 to 20 carbon atoms, a substituted or unsubstituted, branched or cyclic alkyl group having 3 to 70 carbon atoms, a substituted or unsubstituted aliphatic unsaturated hydrocarbon group having 2 to 20 carbon atoms and having one or more double bonds or triple bonds, optionally the alkyl groups and the aliphatic unsaturated hydrocarbon group having an ether group, a thioether group, an ester group, or an amide group, a substituted or unsubstituted aryl group having 6 to 30 carbon atoms, a substituted or unsubstituted arylalkyl group having 6 to 30 carbon atoms, a substituted or unsubstituted triazine ring, a substituted or unsubstituted isocyanuric group, and a substituted or unsubstituted glycoluril group; "n₁" represents an integer of 2 to 6; R₃ represents a substituent other than a hydrogen atom and each independently represents a substituted or unsubstituted alkyl group having 1 to 20 carbon atoms, a substituted or unsubstituted, branched or cyclic alkyl group having 3 to 20 carbon atoms, a substituted or unsubstituted aliphatic unsaturated hydrocarbon group having 2 to 20 carbon atoms and having one or more double bonds or triple bonds, a substituted or unsubstituted alkoxy group having 1 to 20 carbon atoms, a substituted or unsubstituted heteroalkyl group having 1 to 30 carbon atoms, a substituted or unsubstituted aryl group having 6 to 30 carbon atoms, a thiol group, a hydroxy group, an amino group, a carboxy group, or a halogen atom; "l" represents an integer of 0 or 1; "m₁" represents an integer of 0 to 5; X₂ represents a single bond or a linking moiety, the linking moiety being a carbonyl group, an ether group, an ester group, an amide group, an organic group having a valency of "n₂" selected from the group consisting of a substituted or unsubstituted linear alkyl group having 1 to 20 carbon atoms, a substituted or unsubstituted, branched or cyclic alkyl group having 3 to 20 carbon atoms, a substituted or unsubstituted aliphatic unsaturated hydrocarbon group having 2 to 20 carbon atoms and having one or more double bonds or triple bonds, optionally the alkyl group and the aliphatic unsaturated hydrocarbon group having a ketone group, an ether group, an ester group, an amide group, an imine group, a lactone ring, or a sultone ring, a substituted or unsubstituted aryl group having 6 to 36 carbon atoms, a substituted or unsubstituted arylalkyl group having 6 to 36 carbon atoms, and a substituted or unsubstituted triazine ring, or an organic group having a valency of 2×n₂ selected from the group consisting of substituted or unsubstituted, saturated or unsaturated hydrocarbon groups having 2 to 20 carbon atoms and forming a cyclic structure together with the aromatic ring, optionally the hydrocarbon groups having an ether group; and "n₂" represents an integer of 2 to 4.

3. The compound for forming a metal-containing film according to claim 2, wherein the R₁ in the general formulae (M-1) and (M-2) is a substituted or unsubstituted alkyl group having 1 to 20 carbon atoms, a substituted or unsubstituted cycloalkyl group having 3 to 20 carbon atoms, a substituted or unsubstituted aliphatic unsaturated hydrocarbon group having 2 to 20 carbon atoms and having one or more double bonds or triple bonds, a substituted or unsubstituted aryl group having 6 to 30 carbon atoms, or a substituted or unsubstituted arylalkyl group having 7 to 31 carbon atoms.

4. The compound for forming a metal-containing film according to claim 2 or 3, wherein the R₂ represents -OC(=O)R₂', R₂' representing a monovalent organic group.

5. The compound for forming a metal-containing film according to claim 4, wherein the R₂' represents one of the following general formulae (A-1) to (A-4), the following general formula (2), or the following general formula (3), 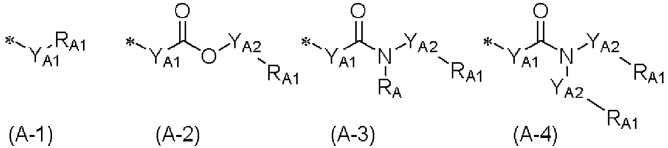 wherein Y_{A1} and Y_{A2} are each identical to or different from each other and represent a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R_{A} represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms; R_{A1} represents an organic group whose protecting group is to be removed by an action of an acid, heat, or both to generate one or more hydroxy groups or carboxyl groups, R_{A1} being represented by one of the following general formulae (1); and "*" represents an attachment point to the carbonyl group, 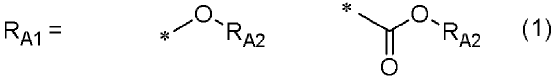 wherein R_{A2} represents an organic group whose protecting group is to be removed by an action of an acid, heat, or both; and "*" represents an attachment point to Y_{A1} or Y_{A2}, 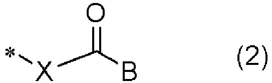 wherein X represents a divalent organic group having 1 to 31 carbon atoms; B represents the following general formula (B); and "*" represents an attachment point to the carbonyl group, 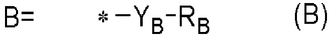 wherein Y_{B} represents a substituted or unsubstituted saturated divalent aliphatic hydrocarbon group having 1 to 20 carbon atoms, a substituted or unsubstituted unsaturated divalent aliphatic hydrocarbon group having 2 to 20 carbon atoms, a substituted or unsubstituted divalent aryl group having 6 to 30 carbon atoms, or a substituted or unsubstituted divalent arylalkyl group having 7 to 31 carbon atoms, optionally Y_{B} being bonded to an adjacent group via an oxygen atom or an NH group; R_{B} represents a hydroxy group or a structure represented by one of the following general formulae (B-1) to (B-3); and "*" represents an attachment point to the carbonyl group, 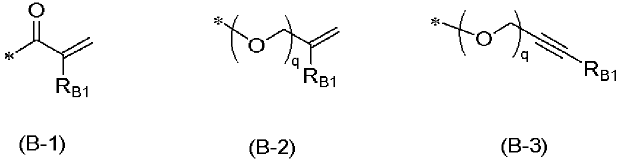 wherein R_{B1} represents a hydrogen atom or a monovalent organic group having 1 to 10 carbon atoms; "q" represents 0 or 1; and "*" represents an attachment point to Y_{B}, 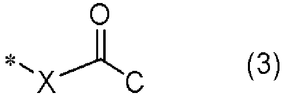 wherein X represents a divalent organic group having 1 to 31 carbon atoms; C represents one of the following general formulae (C-1) to (C-4); and "*" represents an attachment point to the carbonyl group, 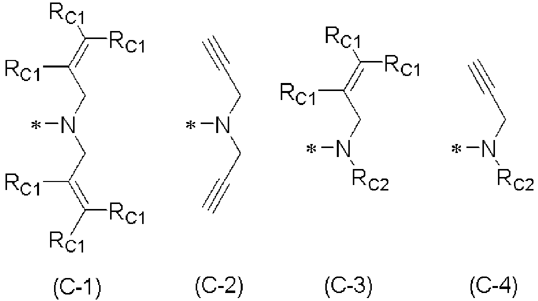 wherein R_{C1}s each independently represent a hydrogen atom or a methyl group and are identical to or different from each other in a single formula; R_{C2} represents a hydrogen atom, a substituted or unsubstituted, saturated or unsaturated monovalent aliphatic hydrocarbon group having 1 to 20 carbon atoms, a substituted or unsubstituted aryl group having 6 to 30 carbon atoms, a substituted or unsubstituted arylalkyl group having 7 to 31 carbon atoms; and "*" represents an attachment point to the carbonyl group.

6. The compound for forming a metal-containing film according to claim 5, wherein the Y_{A1} in the general formulae (A-1) to (A-4), the X in the general formula (2), or the X in the general formula (3) is a substituted or unsubstituted unsaturated divalent hydrocarbon group having 2 to 20 carbon atoms.

7. The compound for forming a metal-containing film according to claim 5 or 6, wherein the Y_{A1} in the general formulae (A-1) to (A-4), the X in the general formula (2), or the X in the general formula (3) represents one of the following general formulae (4), 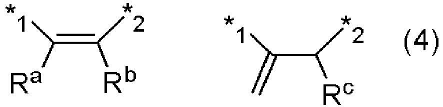 wherein R^{a}, R^{b}, and R^{c} each represent a hydrogen atom or a monovalent organic group having 1 to 20 carbon atoms, R^{a} and R^{b} optionally being bonded to each other to form a cyclic substituent; and "*1" and "*2" each represent an attachment point to the carbonyl group, substitution positions of "*1" and "*2" optionally being reversed.

8. The compound for forming a metal-containing film according to any one of claims 2 to 7, wherein the "m₁" in the general formula (M-2) is 0 or 1, the R₃ being a hydroxy group when m₁=1.

9. The compound for forming a metal-containing film according to any one of claims 1 to 8, wherein the compound for forming a metal-containing film satisfies 1.00 ≤ Mw/Mn ≤ 1.50, where Mw is a weight-average molecular weight and Mn is a number-average molecular weight measured by gel permeation chromatography in terms of polystyrene.

10. A composition for forming a metal-containing film, the composition functioning as a resist underlayer film material used in manufacturing a semiconductor, the composition comprising: (a) the compound for forming a metal-containing film according to any one of claims 1 to 9; and (b) an organic solvent.

11. The composition for forming a metal-containing film according to claim 10, wherein the composition is usable as a resist underlayer film used in a multilayer resist method, the composition further comprising one or more of (c) a crosslinking agent, (d) a surfactant, (e) a flowability accelerator, and (f) an acid generator.

12. The composition for forming a metal-containing film according to claim 10 or 11, wherein the organic solvent (b) is a mixture of one or more kinds of organic solvent having a boiling point of lower than 180°C and one or more kinds of organic solvent having a boiling point of 180°C or higher.

13. A patterning process for forming a pattern in a substrate to be processed, comprising the steps of:
13A)
(I-1) applying the composition for forming a metal-containing film according to any one of claims 10 to 12 onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed; or
13B)
(II-1) applying the composition for forming a metal-containing film according to any one of claims 10 to 12 onto a substrate to be processed, followed by heating to form a metal-containing film;
(II-2) forming a resist middle layer film on the metal-containing film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal-containing film by dry etching while using the resist middle layer film having the transferred pattern as a mask; and
(II-7) processing the substrate to be processed while using the metal-containing film having the formed pattern as a mask to form the pattern in the substrate to be processed; or
13C)
(IV-1) forming a resist underlayer film on a substrate to be processed;
(IV-2) applying the composition for forming a metal-containing film according to any one of claims 10 to 12 onto the resist underlayer film, followed by heating to form a metal-containing film;
(IV-3) forming a resist upper layer film on the metal-containing film by using a photoresist material or forming an organic adhesive film on the metal-containing film by spin-coating and forming a resist upper layer film on the organic adhesive film by using a photoresist material;
(IV-4) subjecting the resist upper layer film to pattern exposure and then development with a developer to form a pattern in the resist upper layer film;
(IV-5) transferring the pattern to the metal-containing film or the organic adhesive film and the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed.

14. A patterning process for forming a pattern in a substrate to be processed, comprising the steps of:
(III-1) applying the composition for forming a metal-containing film according to any one of claims 10 to 12 onto a substrate to be processed, followed by heating to form a metal-containing film;
(III-2) forming an inorganic hard mask middle layer film selected from a silicon oxide film, a silicon nitride film, and a silicon oxynitride film on the metal-containing film, preferably the inorganic hard mask middle layer film being formed by a CVD method or an ALD method;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

15. A patterning process for forming a pattern in a substrate to be processed, comprising the steps of:
(V-1) forming a resist underlayer film on a substrate to be processed;
(V-2) forming a resist middle layer film or a combination of an organic thin film and an inorganic hard mask middle layer film selected from a silicon oxide film, a silicon nitride film, and a silicon oxynitride film on the resist underlayer film, preferably the inorganic hard mask middle layer film being formed by a CVD method or an ALD method;
(V-3) forming a resist upper layer film on the resist middle layer film or the combination of the organic thin film and the inorganic hard mask middle layer film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the composition for forming a metal-containing film according to any one of claims 10 to 12 onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing, by dry etching, the resist underlayer film having the formed pattern with an exposed surface to form a reverse pattern of an original pattern on the metal-containing film; and
(V-11) processing the substrate to be processed while using the metal-containing film having the formed reverse pattern as a mask to form the reverse pattern in the substrate to be processed.
